(19) Europäisches Patentamt
European Patent Office
Office européen des brevets

(11) **EP 4 783 059 A1**

(12) **EUROPEAN PATENT APPLICATION**

(43) Date of publication:
**29.07.2026 Bulletin 2026/31**

(21) Application number: **25222063.7**

(22) Date of filing: **10.12.2025**

(51) International Patent Classification (IPC):
**G06F 30/20** (2020.01)   **G06F 30/27** (2020.01)
**G06F 40/30** (2020.01)   **G06N 5/022** (2023.01)

(52) Cooperative Patent Classification (CPC):
**G06F 30/27; G06F 30/20; G06F 40/20; G06F 40/30;
G06N 5/022; G06N 20/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **22.01.2025 IN 202521005381**

(71) Applicant: **Tata Consultancy Services Limited
Maharashtra (IN)**

(72) Inventors:
• **JADHAV, Vishal Sudam
  411057 Pune, Maharashtra (IN)**
• **NAGARVANSHI, Bhavesh
  411057 Pune, Maharashtra (IN)**
• **KARANDE, Shirish Subhash
  411006 Yerwada Pune, Maharashtra (IN)**
• **RUNKANA, Venkataramana
  411028 Pune, Maharashtra (IN)**

(74) Representative: **Goddar, Heinz J.
Boehmert & Boehmert
Anwaltspartnerschaft mbB
Pettenkoferstrasse 22
80336 München (DE)**

(54) **METHOD AND SYSTEM FOR COMPUTATIONAL ANALYSIS OF INDUSTRIAL ENTITIES USING MULTIMODAL LARGE LANGUAGE MODEL (LLM)**

(57) Computational analysis is essential for efficient design, evaluation, and prediction of processes in industrial systems. However, it requires significant expertise, iterative refinement, and labor-intensive efforts. Embodiments herein provide a method and system for computational analysis of industrial entities using a multimodal Large Language Model (LLM). A plurality of final assumptions required for a plurality of workflows of the computational analysis of the industrial entity are generated by the multimodal LLM. Further the method creates a plurality of prompts based on the generated plurality of final assumptions. A Computer-Aided-Design (CAD) file, a final mesh file, a solver results file, and a plurality of computational analysis result insights are generated using the plurality of prompts, via the multimodal LLM. The method of the present disclosure minimizes user involvement, utilizes a knowledge base to generate relevant outputs, and offers flexibility for seamless integration with various software platforms and tools for the computational analysis.

FIG. 2

# EP 4 783 059 A1

**Description**

CROSS-REFERENCE TO RELATED APPLICATIONS AND PRIORITY

The present application claims priority to Indian application no. 202521005381, filed on January 22, 2025.

TECHNICAL FIELD

The disclosure herein generally relates to computational analysis, and, more particularly, to a method and system for the computational analysis of industrial entities using multimodal large language model (LLM).

BACKGROUND

As industries evolve, the demand for efficiency, precision, and sustainability in engineering processes has grown significantly. Computational analysis has become a cornerstone of modem engineering, enabling simulation of complex systems to optimize designs and predict outcomes. The computational analysis involves the use of algorithms to solve mathematical equations that describe natural and industrial processes. For example, the Navier-Stokes equations, which model fluid dynamics, are crucial for understanding the behavior of systems ranging from atmospheric flows to industrial reactors. These equations are often too complex to solve analytically, so numerical methods like Finite Volume Methods (FVM), Finite Element Methods (FVM), Finite Difference Methods (FDM) are employed to approximate solutions. The computational analysis thus bridges the gap between theoretical models and practical applications, allowing engineers to simulate and predict real-world phenomena with remarkable accuracy.

Traditional computational analysis, despite its capabilities, encounters several critical challenges. Engineers must manually create Computer-Aided Design (CAD) models of an industrial entity, generate a mesh to discretize geometry, and set up governing equations along with boundary conditions. This labor-intensive process demands a high level of expertise and considerable time to produce accurate results. CAD modeling demands meticulous attention to detail, particularly for complex geometries, while mesh generation often requires precise refinements tailored to specific problems. These tasks necessitate specialized expertise in the CAD modelling and the mesh generation, often involving a team of professionals. Iterative adjustments based on final outputs add to the time-intensive nature of the process. Consequently, a typical CFD project for real-world applications can span anywhere from several days to weeks, heavily influenced by the availability and proficiency of the team. Solver configuration introduces further complexities, as selecting suitable turbulence models, numerical schemes, and boundary conditions is not only time-consuming but also prone to errors. Additionally, the vast body of scientific literature remains largely untapped, depriving engineers of valuable insights into best practices and innovative techniques. This fragmented, expertise-dependent workflow restricts accessibility and scalability, highlighting the urgent need for a transformative solution. Hence traditional computational analysis workflow relies heavily on human expertise, creating bottlenecks and variability in results.

SUMMARY

Embodiments of the present disclosure present technological improvements as solutions to one or more of the above-mentioned technical problems recognized by the inventors in conventional systems. For example, in one embodiment, a method for computational analysis of industrial entities using multimodal large language model (LLM) is provided. The method includes receiving a user input comprising at least one of (a) one or more information documents, (b) a technical problem description, (c) a natural language description, (d) a reference engineering drawing, and (e) a plurality of web resources pertaining to a computational analysis of an industrial entity. Further the method includes generating a plurality of questions, by a multimodal Large Language Model (LLM), based on the user input, wherein the plurality of questions pertains to a computational analysis information required by a plurality of workflows of the computational analysis of the industrial entity, and wherein the computational analysis information of the plurality of workflows comprises a geometry creation information, a mesh related information, a solver setup related information, and a postprocessing information. Furthermore the method includes generating a plurality of final assumptions, by the multimodal LLM, based on (i) a plurality of associated answers for the plurality of questions generated by the multimodal LLM, (ii) the user input, and (iii) an information extracted via a first search and a second search using a Retrieval-Augmented Generation (RAG) technique, wherein the information extracted via the first search and the second search comprises a set of answers for a set of skipped questions among the plurality of questions. Furthermore, the method includes categorizing the plurality of final assumptions into a plurality of current categorized assumptions comprising a plurality of current geometry assumptions, a plurality of current mesh assumptions, a plurality of current solver setup assumptions, and a plurality of current computational analysis result insight assumptions, based on the plurality of workflows of the computational analysis of the industrial entity. Furthermore the method includes extracting a plurality of existing categorized assumptions based on the plurality of current categorized assumptions by the first search using the RAG technique, wherein the existing categorized assumptions comprises (i) a plurality of existing geometry assumptions, (ii) a plurality of existing mesh assumptions, (iii) a plurality of existing solver setup assumptions, and (iv) a plurality of existing computational analysis result insight assumptions in the knowledge base. Furthermore the method includes identifying one or more matched categorized assumptions, and one or more unmatched categorized assumptions by comparing the plurality of current categorized assumptions with the plurality of existing categorized assumptions, wherein if one or more current categorized assumptions of the plurality of current categorized assumptions is exactly matching with one or more existing categorized assumptions of the plurality of existing categorized assumptions, the one or more matched categorized assumptions are replaced with a set of instructions to enable the multimodal LLM for executing a predefined fetching function, by the multimodal LLM, to generate one or more modified matched assumptions. Furthermore the method includes creating a plurality of prompts comprising (i) a geometry creation prompt, (ii) a mesh creation prompt, (iii) a solver setup script creation prompt, (iv) and a computational analysis result insight prompt, by the multimodal LLM, based on the one or more modified matched assumptions, and the one or more unmatched categorized assumptions further the method includes generating a Computer-Aided Design (CAD) file for the computational analysis of the industrial entity, using the geometry creation prompt, via the multimodal LLM. Furthermore, the method includes generating a final mesh file for the computational analysis of the industrial entity, using the mesh creation prompt, and the generated CAD file, via the multimodal LLM. Further the method includes generating a solver results file for the computational analysis of the industrial entity, using the solver setup script creation prompt, and the generated final mesh file, via the multimodal LLM. The method finally includes generating a plurality of computational analysis result insights for the computational analysis of the industrial entity, using the computational analysis result insight prompt and the generated solver results file, via the multimodal LLM.

In another aspect, a system for computational analysis of industrial entities using multimodal large language model (LLM) is provided. The system includes a memory (102) storing instructions; one or more communication interfaces (106); and one or more hardware processors (104) coupled to the memory (102) via the one or more communication interfaces (106), wherein the one or more hardware processors (104) are configured by the instructions to: receive a user input comprising at least one of (a) one or more information documents, (b) a technical problem description, (c) a natural language description, (d) a reference engineering drawing, and (e) a plurality of web resources pertaining to a computational analysis of an industrial entity; generate a plurality of questions, by a multimodal Large Language Model (LLM), based on the user input, wherein the plurality of questions pertains to a computational analysis information required by a plurality of workflows of the computational analysis of the industrial entity, and wherein the computational analysis information of the plurality of workflows comprises a geometry creation information, a mesh related information, a solver setup related information, and a postprocessing information; generate a plurality of final assumptions, by the multimodal LLM, based on (i) a plurality of associated answers for the plurality of questions generated by the multimodal LLM, (ii) the user input, and (iii) an information extracted via a first search and a second search using a Retrieval-Augmented Generation (RAG) technique, wherein the information extracted via the first search and the second search comprises a set of answers for a set of skipped questions among the plurality of questions; categorize the plurality of final assumptions into a plurality of current categorized assumptions comprising a plurality of current geometry assumptions, a plurality of current mesh assumptions, a plurality of current solver setup assumptions, and a plurality of current computational analysis result insight assumptions, based on the plurality of workflows of the computational analysis of the industrial entity; extract a plurality of existing categorized assumptions based on the plurality of current categorized assumptions by the first search using the RAG technique, wherein the existing categorized assumptions comprises (i) a plurality of existing geometry assumptions, (ii) a plurality of existing mesh assumptions, (iii) a plurality of existing solver setup assumptions, and (iv) a plurality of existing computational analysis result insight assumptions in the knowledge base; identify one or more matched categorized assumptions, and one or more unmatched categorized assumptions by comparing the plurality of current categorized assumptions with the plurality of existing categorized assumptions, wherein if one or more current categorized assumptions of the plurality of current categorized assumptions is exactly matching with one or more existing categorized assumptions of the plurality of existing categorized assumptions, the one or more matched categorized assumptions are replaced with a set of instructions to enable the multimodal LLM for executing a predefined fetching function, by the multimodal LLM, to generate one or more modified matched assumptions; create a plurality of prompts comprising (i) a geometry creation prompt, (ii) a mesh creation prompt, (iii) a solver setup script creation prompt, (iv) and a computational analysis result insight prompt, by the multimodal LLM, based on the one or more modified matched assumptions, and the one or more unmatched categorized assumptions; generate a Computer-Aided Design (CAD) file for the computational analysis of the industrial entity, using the geometry creation prompt, via the multimodal LLM; generate a final mesh file for the computational analysis of the industrial entity, using the mesh creation prompt, and the generated CAD file, via the multimodal LLM; generate a solver results file for the computational analysis of the industrial entity, using the solver setup script creation prompt, and the generated final mesh file, via the multimodal LLM; and generate a plurality of computational analysis result insights for the computational analysis of the industrial entity, using the computational analysis result insight prompt and the generated solver results file, via the multimodal LLM.

In yet another aspect, there are provided one or more non-transitory machine-readable information storage mediums comprising one or more instructions which when executed by one or more hardware processors cause a method for computational analysis of industrial entities using multimodal large language model (LLM) is provided. The method includes receiving a user input comprising at least one of (a) one or more information documents, (b) a technical problem description, (c) a natural language description, (d) a reference engineering drawing, and (e) a plurality of web resources pertaining to a computational analysis of an industrial entity. Further the method includes generating a plurality of questions, by a multimodal Large Language Model (LLM), based on the user input, wherein the plurality of questions pertains to a computational analysis information required by a plurality of workflows of the computational analysis of the industrial entity, and wherein the computational analysis information of the plurality of workflows comprises a geometry creation information, a mesh related information, a solver setup related information, and a postprocessing information. Furthermore the method includes generating a plurality of final assumptions, by the multimodal LLM, based on (i) a plurality of associated answers for the plurality of questions generated by the multimodal LLM, (ii) the user input , and (iii) an information extracted via a first search and a second search using a Retrieval-Augmented Generation (RAG) technique, wherein the information extracted via the first search and the second search comprises a set of answers for a set of skipped questions among the plurality of questions. Furthermore, the method includes categorizing the plurality of final assumptions into a plurality of current categorized assumptions comprising a plurality of current geometry assumptions, a plurality of current mesh assumptions, a plurality of current solver setup assumptions, and a plurality of current computational analysis result insight assumptions, based on the plurality of workflows of the computational analysis of the industrial entity. Furthermore the method includes extracting a plurality of existing categorized assumptions based on the plurality of current categorized assumptions by the first search using the RAG technique, wherein the existing categorized assumptions comprises (i) a plurality of existing geometry assumptions, (ii) a plurality of existing mesh assumptions, (iii) a plurality of existing solver setup assumptions, and (iv) a plurality of existing computational analysis result insight assumptions in the knowledge base. Furthermore the method includes identifying one or more matched categorized assumptions, and one or more unmatched categorized assumptions by comparing the plurality of current categorized assumptions with the plurality of existing categorized assumptions, wherein if one or more current categorized assumptions of the plurality of current categorized assumptions is exactly matching with one or more existing categorized assumptions of the plurality of existing categorized assumptions, the one or more matched categorized assumptions are replaced with a set of instructions to enable the multimodal LLM for executing a predefined fetching function, by the multimodal LLM, to generate one or more modified matched assumptions. Furthermore the method includes creating a plurality of prompts comprising (i) a geometry creation prompt, (ii) a mesh creation prompt, (iii) a solver setup script creation prompt, (iv) and a computational analysis result insight prompt, by the multimodal LLM, based on the one or more modified matched assumptions, and the one or more unmatched categorized assumptions further the method includes generating a Computer-Aided Design (CAD) file for the computational analysis of the industrial entity, using the geometry creation prompt, via the multimodal LLM. Furthermore, the method includes generating a final mesh file for the computational analysis of the industrial entity, using the mesh creation prompt, and the generated CAD file, via the multimodal LLM. Further the method includes generating a solver results file for the computational analysis of the industrial entity, using the solver setup script creation prompt, and the generated final mesh file, via the multimodal LLM. The method finally includes generating a plurality of computational analysis result insights for the computational analysis of the industrial entity, using the computational analysis result insight prompt and the generated solver results file, via the multimodal LLM.

It is to be understood that both the foregoing general description and the following detailed description are exemplary and explanatory only and are not restrictive of the invention, as claimed.

BRIEF DESCRIPTION OF THE DRAWINGS

The accompanying drawings, which are incorporated in and constitute a part of this disclosure, illustrate exemplary embodiments and, together with the description, serve to explain the disclosed principles:

FIG. 1 illustrates an exemplary system for computational analysis of industrial entities using a multimodal large language model (LLM), according to some embodiments of the present disclosure.
FIG. 2 is a functional architecture depicting process flow of the system for the computational analysis of the industrial entities using the multimodal large language model LLM, according to some embodiments of the present disclosure.
FIGS. 3A, and 3B depict a flow diagram of a method for the computational analysis of the industrial entities using the multimodal large language model LLM, according to some embodiments of the present disclosure.
FIG. 4 depicts a Computer-Aided Design (CAD) model obtained by executing a CAD script for the computational analysis of the industrial entities, according to some embodiments of the present disclosure.
FIG. 5 depicts a final mesh file for the computational analysis of the industrial entity, according to some embodiments of the present disclosure.
FIGS. 6A, and 6B depict a plurality of visualizations generated by the multimodal LLM for the computational analysis of the industrial entities, according to some embodiments of the present disclosure.

It should be appreciated by those skilled in the art that any block diagrams herein represent conceptual views of illustrative systems and devices embodying the principles of the present subject matter. Similarly, it will be appreciated that any flow charts, flow diagrams, and the like represent various processes which may be substantially represented in computer readable medium and so executed by a computer or processor, whether or not such computer or processor is explicitly shown

DETAILED DESCRIPTION OF EMBODIMENTS

Exemplary embodiments are described with reference to the accompanying drawings. In the figures, the left-most digit(s) of a reference number identifies the figure in which the reference number first appears. Wherever convenient, the same reference numbers are used throughout the drawings to refer to the same or like parts. While examples and features of disclosed principles are described herein, modifications, adaptations, and other implementations are possible without departing from the scope of the disclosed embodiments.

The evolution of Large Language Models (LLMs) from simple dialogue systems to agent-based frameworks underscores their increasing capacity to perform intelligent actions and address complex problems across various disciplines. Computational analysis is one such domain that can benefit from LLMs' multidisciplinary knowledge and advanced automation capabilities. While LLMs have not yet reached the sophistication required to replace conventional computational analysis solvers, they can significantly reduce human effort by assisting in the setting up of the computational analysis simulations. A typical computational analysis workflow comprises spanning problem definition, Computer-Aided Design (CAD) modeling, mesh generation, generating solver results, and post-processing which remains labor-intensive and prone to user errors, posing substantial challenges in the field.

Preparing the computational analysis simulations presents multiple challenges across various stages. In the CAD modeling, engineers must carefully manage every curve, feature, and tolerance, as complex CAD software requires substantial expertise to efficiently handle intricate assemblies and part features. The mesh generation poses additional difficulties, as small features, curved surfaces, and sharp edges often demand highly refined meshes that are computationally expensive and challenging to create. Additionally, generating the solver results involves simplifying the Navier-Stokes equations, necessitating careful selection of turbulence models, boundary conditions, and numerical methods. These decisions are situation-specific and prone to human error, often leading to discrepancies between simulation results and real-world behavior. For novice users, accessing the required expertise can be challenging due to inadequate documentation and complex workflows.

Recent advancements in the LLMs, such as Generative Pre-Trained Transformers (GPTs), have opened new avenues for automating domain-specific tasks, including CFD workflows. For example, in existing work "Kumar, V., Gleyzer, L., Kahana, A., Shukla, K., & Karniadakis, G. E. (2023). MyCrunchGPT: A chatGPT assisted framework for scientific machine learning" introduced MyCrunchGPT to automate scientific machine learning workflows, with a focus on replacing traditional computational analysis solvers for specific problems. However, this approach limits broader applicability. Similarly, in another existing work "Picard, C., Edwards, K. M., Doris, A. C., Man, B., Giannone, G., Alam, M. F., & Ahmed, F. (2023). From Concept to Manufacturing: Evaluating Vision-Language Models for Engineering Design." explored the use of GPT-4V in engineering design, but did not demonstrate a comprehensive, end-to-end computational analysis process. Further in another existing work "Alexiadis, A., & Ghiassi, B. (2024). From text to tech: Shaping the future of physics-based simulations with AI-driven generative models. Results in Engineering, 21, 101721." provided advanced LLM applications by automating geometry creation, mesh generation, and solver setup for solid mechanics simulations. However, their approach relies on default configurations and is restricted to simple geometries.

Embodiments herein provide a method and system for the computational analysis of industrial entities using a multimodal LLM. The method generates a plurality of questions, by using the multimodal LLM, based on a user input. A plurality of final assumptions is generated, by using the multimodal LLM, based on a plurality of associated answers for the plurality of questions generated by the multimodal LLM, the user input, and information extracted via a first search and a second search using a Retrieval-Augmented Generation (RAG) technique. The plurality of final assumptions is categorized into a plurality of current categorized assumptions. A plurality of existing categorized assumptions is extracted based on the plurality of current categorized assumptions by the first search using the RAG technique. Further one or more matched categorized assumptions, and one or more unmatched categorized assumptions are identified by comparing the plurality of current categorized assumptions with the plurality of existing categorized assumptions, by looking for an exact match. Further the method creates a plurality of prompts based on one or more modified matched assumptions, and the one or more unmatched categorized assumptions. A CAD file is generated using a geometry creation prompt, a final mesh file is generated using a mesh creation prompt, and the generated CAD file, a solver results file is generated using a solver setup script creation prompt, and the generated final mesh file, and a plurality of computational analysis result insights is generated using a computational analysis result insight prompt and the generated solver results file, via the multimodal LLM.

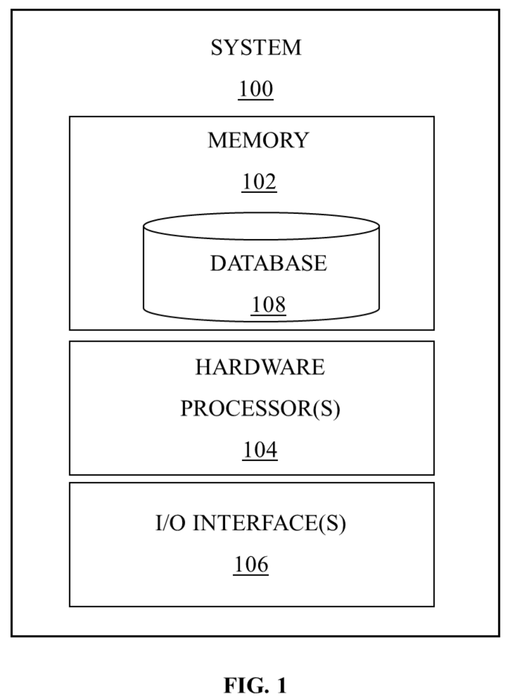

Referring now to the drawings, and more particularly to FIG. 1 through FIG. 6B, where similar reference characters denote corresponding features consistently throughout the figures, there are shown preferred embodiments, and these embodiments are described in the context of the following exemplary system and/or method.

FIG. 1 is a functional block diagram of a system 100 for the computational analysis of the industrial entities using the multimodal LLM, according to some embodiments of the present disclosure. In an embodiment, the system 100 includes one or more hardware processors 104, communication interface device(s) or input/output (I/O) interface(s) 106 (also referred as interface(s)), and one or more data storage devices or memory 102 operatively coupled to the one or more hardware processors 104. The one or more processors 104 may be one or more software processing components and/or hardware processors.

Referring to the components of the system 100, in an embodiment, the processor (s) 104 can be the one or more hardware processors 104. In an embodiment, the one or more hardware processors 104 can be implemented as one or more microprocessors, microcomputers, microcontrollers, digital signal processors, central processing units, state machines, logic circuitries, and/or any devices that manipulate signals based on operational instructions. Among other capabilities, the processor(s) 104 is/are configured to fetch and execute computer-readable instructions stored in the memory. In an embodiment, the system 100 can be implemented in a variety of computing systems, such as laptop computers, notebooks, hand-held devices (e.g., smartphones, tablet phones, mobile communication devices, and the like), workstations, mainframe computers, servers, a network cloud, and the like.

The I/O interface(s) 106 can include a variety of software and hardware interfaces, for example, a web interface, a graphical user interface, and the like and can facilitate multiple communications within a wide variety of networks N/W and protocol types, including wired networks, for example, LAN, cable, etc., and wireless networks, such as WLAN, cellular, or satellite. In an embodiment, the I/O interface (s) 106 can include one or more ports for connecting a number of devices to one another or to another server.

The memory 102 may include any computer-readable medium known in the art including, for example, volatile memory, such as static random access memory (SRAM) and dynamic random access memory (DRAM), and/or non-volatile memory, such as read only memory (ROM), erasable programmable ROM, flash memories, hard disks, optical disks, and magnetic tapes. Thus, the memory 102 may comprise information pertaining to input(s)/output(s) of each step performed by the processor(s) 104 of the system 100 and methods of the present disclosure. In an embodiment, a database 108 is comprised in the memory 102, wherein the database 108 comprises information on one or more information documents, a technical problem description, a natural language description, a reference engineering drawing, a plurality of web resources, the plurality of questions, a geometry creation information, a meshing related information, a solver related information, and a postprocessing information, the plurality of final assumptions, a predefined knowledge base, a plurality of geometry assumptions, a plurality of mesh assumptions, a plurality of solver setup assumptions, a plurality of computational analysis result insight assumptionsThe database 108 further comprises information on the plurality of prompts, the CAD file, the final mesh file, the solver results file, the plurality of computational analysis result insights, and the like. The memory 102 further comprises a plurality of modules (not shown for various technique(s) such as, the multimodal LLM, the RAG technique, a CAD modeler, and thereof. The above-mentioned technique(s) are implemented as at least one of a logically self-contained part of a software program, a self-contained hardware component, and/or, a self-contained hardware component with a logically self-contained part of a software program embedded into each of the hardware component (e.g., hardware processor 104 or memory 102) that when executed perform the method described herein. The memory 102 further comprises (or may further comprise) information pertaining to input(s)/output(s) of each step performed by the systems and methods of the present disclosure. In other words, input(s) fed at each step and output(s) generated at each step are comprised in the memory 102 and can be utilized in further processing and analysis.

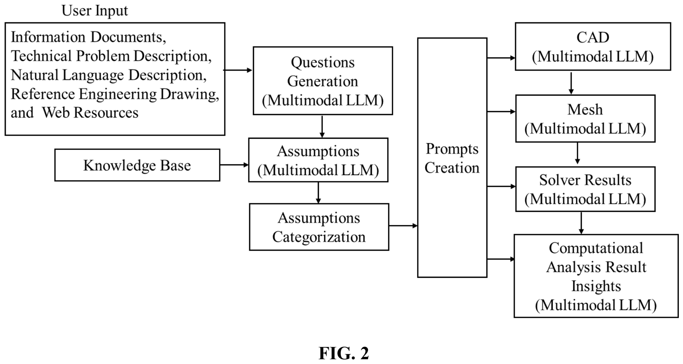

FIG. 2 is a functional architecture depicting process flow of the system 100 for the computational analysis of the industrial entities using multimodal LLM, according to some embodiments of the present disclosure. The system 100 receives the user input comprising at least one of (a) the one or more information documents (b) the technical problem description, (c) the natural language description, (d) the reference engineering drawing, and (e) the plurality of web resources pertaining to the computational analysis of the industrial entity via a User Input component as depicted in FIG. 2. The plurality of questions is generated via the Questions Generation component, by the multimodal LLM, based on the user input. Then the plurality of final assumptions is generated via an Assumptions component, by the multimodal LLM, based on the plurality of associated answers for the plurality of questions generated by the multimodal LLM, the user input, and information extracted via the first search and the second search using the RAG technique. At an Assumption component of the FIG. 2 the plurality of final assumptions is categorized based on a plurality of workflows of the computational analysis of the industrial entity. The plurality of final assumptions is categorized into the plurality of current categorized assumptions. The plurality of existing categorized assumptions is extracted based on the plurality of current categorized assumptions by the first search using the RAG technique. Further the one or more matched categorized assumptions, and one or more unmatched categorized assumptions are identified by comparing the plurality of current categorized assumptions with the plurality of existing categorized assumptions, by looking for the exact match. A Prompts Creation component in FIG. 2 creates the plurality of prompts based on the one or more modified matched assumptions, and the one or more unmatched categorized assumptions. A CAD component generates the CAD file, using the geometry creation prompt, via multimodal LLM. A Mesh component generates the final mesh file, using the mesh creation prompt, and the generated CAD file, via the multimodal LLM. A Solver component in FIG. 2 generates the solver results file, using the solver setup script creation prompt, and the generated final mesh file, via the multimodal LLM. A Computational Analysis Result Insights component generates the plurality of computational analysis result insights, using the computational analysis result insight prompt and the generated solver results file, via the multimodal LLM.

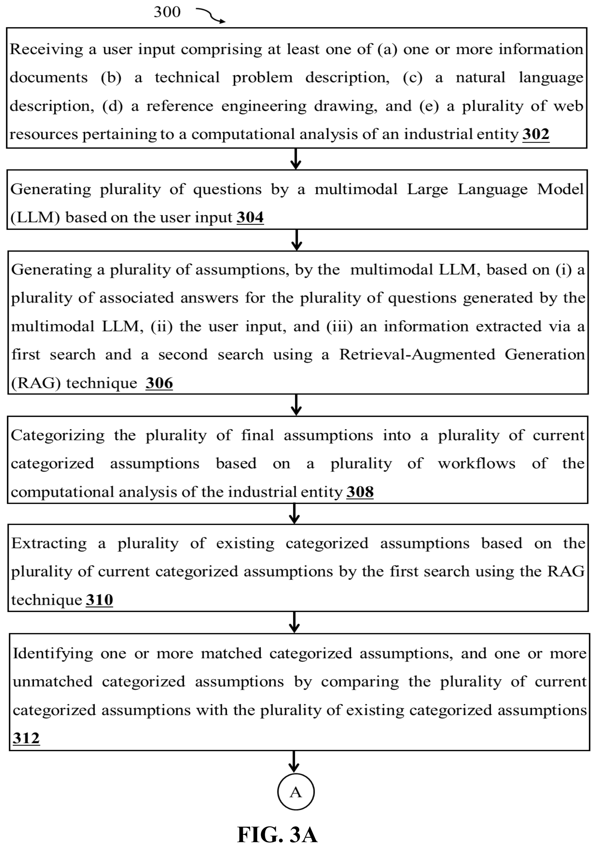

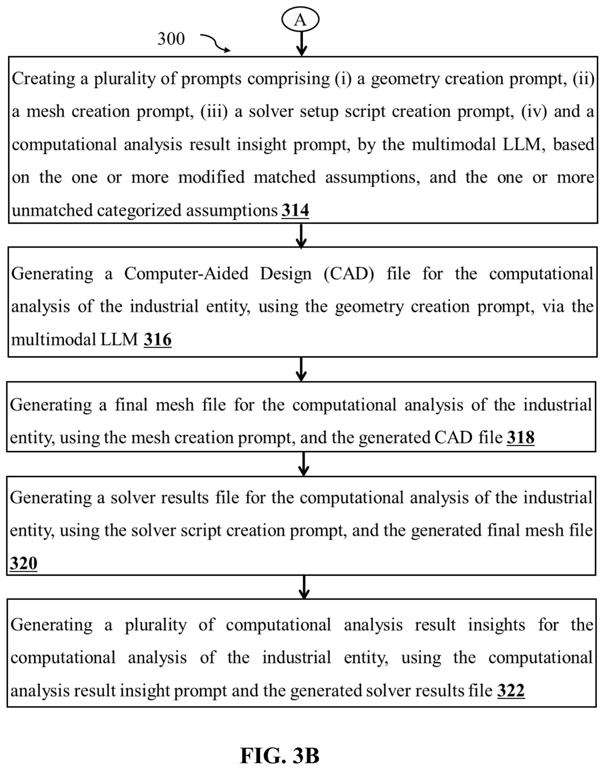

FIGS. 3A, and 3B is a flow diagram depicting a method 300 for computational analysis of the industrial entities using the multimodal LLM, using the system of FIG. 1, according to some embodiments of the present disclosure.

In an embodiment, the system 100 comprises one or more data storage devices or the memory 102 operatively coupled to the processor(s) 104 and is configured to store instructions for execution of steps of the method 300 by the processor(s) 104. The steps of the method 300 of the present disclosure will now be explained with reference to the components or blocks of the system 100 as depicted in FIG. 1, the architecture diagram depicted in FIG. 2, and the steps of flow diagram as depicted in FIGS. 3A, and 3B. Although process steps, method steps, techniques or the like may be described in a sequential order, such processes, methods and techniques may be configured to work in alternate orders. In other words, any sequence or order of steps that may be described does not necessarily indicate a requirement that the steps to be performed in that order. The steps of processes described herein may be performed in any order practically. Further, some steps may be performed simultaneously.

Referring to steps of FIG. 3A, at step 302 of the method 300, the one or more hardware processors 104 are configured to receive the user input comprising at least one of (a) the one or more information documents (b) the technical problem description, (c) the natural language description, (d) the reference engineering drawing, and (e) the plurality of web resources pertaining to the computational analysis of the industrial entity. The one or more information documents are the documents provided by the user comprising (a) an instruction manual that contains a plurality of instructions to setup the computational analysis (b) a published or unpublished research article. The technical problem description is a document comprising a geometry information, a mesh configuration information, a physics setup information, and a visualization information. The natural language description comprises a broad information that might or might not contain all the information required for the computational analysis. The plurality of web resources comprises various blogs, tutorials, and thereof.

At step 304 of the method 300, the one or more hardware processors 104 are configured to generate the plurality of questions, by the multimodal LLM, based on the user input. The plurality of questions pertains to the computational analysis information required by the plurality of workflows of the computational analysis of the industrial entity. The computational analysis information of the plurality of workflows comprises the geometry creation information, the meshing related information, the solver related information, and the postprocessing information. The geometry creation information comprises a plurality of domain dimensions, a plurality of boundary coordinates, a plurality of key features, a plurality of geometry constraints, the CAD modeler, a plurality annotated figures, one or more irregularities, one or more shapes, one or more units, a nomenclature, a topology, and thereof. The meshing related information comprises a mesh size range, a plurality of boundary conditions, a mesh type, a phase information, a plurality of boundary layers, and thereof. The solver related information comprises one or more governing equations, one or more materials, one or more solver configurations, the plurality of boundary conditions, one or more numerical schemes, and a plurality of iterations. The postprocessing information comprises one or more required result and a plurality of visualizations.

The multimodal LLM analyzes the user input and checks whether the user input is sufficient for the plurality of workflows of the computational analysis of the industrial entity. Then the multimodal LLM generates the plurality of questions based on a missing information from the user input that is required by the plurality of workflows of the computational analysis of the industrial entity. The user provides a plurality of associated answers, for the plurality of questions generated by the multimodal LLM. The user might skip a set of questions among the plurality of questions. The set of questions unanswered by the user forms a set of skipped questions.

At step 306 of the method 300, the one or more hardware processors 104 are configured to generate the plurality of final assumptions, by the multimodal LLM, based on the (i) plurality of associated answers, for the plurality of questions generated by the multimodal LLM, (ii) the user input, and (iii) an information extracted via the first search and the second search using the RAG technique. The computational analysis information required by the plurality of workflows of the computational analysis of the industrial entity for the set of skipped questions among the plurality of questions is extracted via the first search and the second search using the RAG technique.

The first search is a knowledge base search performed on the predefined knowledge base based on the user input, according to some embodiments of the present disclosure. The predefined knowledge base comprises at least one of (a) a plurality of structured resources, and (b) a plurality of unstructured resources related to a domain of the user input comprising a plurality of predefined knowledge base entries. The plurality of predefined knowledge base entries comprises an information source metadata, the technical problem description, a plurality of geometry assumptions, a CAD script, the CAD file, a plurality of mesh assumptions, a plurality of mesh configurations, the final mesh file, a plurality of solver setup assumptions, a solver setup script, the solver results file, a plurality of computational analysis result insight assumptions, the post-processing script, the plurality of visualizations, and the plurality of computational analysis result insights.

The predefined knowledge base with the plurality of structured resources comprising tabular resource is defined as the plurality of predefined knowledge base entries, where each entry pertains to a problem processed by the disclosed method. Each entry of the plurality of predefined knowledge base entries consists of columns containing specific types of information represented as:

$$K = \{k_1, k_2, \ldots, k_n\}$$

where $k_i$ represents the $i_{th}$ problem entry, and $n$ is the total number of stored problems. Each entry $k_i$ is a tuple comprising the information source metadata, the technical problem description, the plurality of geometry assumptions, the CAD script, the CAD file, the plurality of mesh assumptions, the plurality of mesh configurations, the final mesh file, the plurality of solver setup assumptions, the solver setup script, the solver results file, the plurality of computational analysis result insight assumptions, the post-processing script, the plurality of visualizations, and the plurality of computational analysis result insights. The second search is an internet search according to some embodiments of the present disclosure.

The steps for generating the plurality of final assumptions, by the multimodal LLM, using the RAG technique comprises:

(a) Performing the first search and a second search on the user input and the plurality of associated answers for the plurality of questions generated, by the multimodal LLM, using the RAG technique, to obtain the missing information required by the plurality of workflows of the computational analysis.

(b) Generating a plurality of initial assumptions serving as the plurality of final assumptions using the user input, the plurality of associated answers of the plurality of questions, and the missing information based on one of (i) an acceptance confirmation by the user, and (ii) one or more associated modifications applied to the plurality of initial assumptions. The plurality of initial assumptions is generated based on the user input and the plurality of associated answers of the plurality of questions and the missing information retrieved from the first search and the second search. If the plurality of initial assumptions is confirmed by the user, the plurality of initial assumptions is accepted as the plurality of final assumptions. If the plurality of initial assumptions is modified by the user, the changes are applied, and the plurality of initial assumptions are iteratively refined to produce the plurality of final assumptions.

Upon generating the plurality of final assumptions, at step 308 of the method 300, the one or more hardware processors 104 are configured to categorize the plurality of final assumptions into the plurality of current categorized assumptions comprising a plurality of current geometry assumptions, a plurality of current mesh assumptions, a plurality of current solver setup assumptions, and a plurality of current computational analysis result insight assumptions, based on the plurality of workflows of the computational analysis of the industrial entity.

At step 310 of the method 300, the one or more hardware processors 104 are configured to extract a plurality of existing categorized assumptions based on the plurality of current categorized assumptions by the first search using the RAG technique. The existing categorized assumptions comprise (i) a plurality of existing geometry assumptions, (ii) a plurality of existing mesh assumptions, (iii) a plurality of existing solver setup assumptions, and (iv) a plurality of existing computational analysis result insight assumptions in the knowledge base. The plurality of existing categorized assumptions belongs to the $k_i^{th}$ tuple on the knowledge base which was retrieved based on its similarity with the plurality of current categorized assumption.

At step 312 of the method 300, the one or more hardware processors 104 are configured to identify the one or more matched categorized assumptions, and one or more unmatched categorized assumptions by comparing the plurality of current categorized assumptions with the plurality of existing categorized assumptions. If one or more current categorized assumptions of the plurality of current categorized assumptions exactly match with one or more existing categorized assumptions of the plurality of existing categorized assumptions, the one or more matched categorized assumptions are replaced with a set of instructions to enable the multimodal LLM for executing a predefined fetching function, by the multimodal LLM, to generate one or more modified matched assumptions.

At step 314 of the method 300, the one or more hardware processors 104 are configured to create the plurality of prompts comprising (i) the geometry creation prompt, (ii) the mesh creation prompt, (iii) the solver setup script creation prompt using, (iv) and the computational analysis result insight prompt, by the multimodal LLM, based on the one or more modified matched assumptions, and the one or more unmatched categorized assumptions. For example, the geometry creation prompt is created as "Taking the given description and schematic attached as image {bubble_column _original.png} into context generate a CADQuery script for CAD model creation. The geometry consists of a rectangular bubble column with dimensions: width = 0.2 m, height = 1.2 m, and depth = 0.05 m. Include a rectangular pitch of width 18mm and height 6mm at the center of the bottom cross-section of the bubble column lying horizontally Generate the model script and export it to 'bubble_column_model.step'."

For example, the mesh creation prompt is as follows "the geometry filename is 'bubble_column_model.step'. Here is the input description for mesh generation: setup type: 0, Cell sizes: Coarse mesh: Min cell size: 0.01 m, Max cell size: 0.048 m, Fine mesh: Min cell size: 0.01 m, Max cell size: 0.01333 m; All cell sizes are in meters (m) Export the mesh as 'bubble_column_model.msh'." For example solver setup script creation prompt is as follows: "write pyfluent settings Application Programming Interface (API) commands for the following query: Step 1: Initialize the Solver Settings\n\tStart ANSYS Fluent and select the Pressure-based solver\n\tSet Time Stepping to steady \n\nImport the mesh file named "bubble_column_model.msh" and rescale it to meters. Step 2: Define the Fluid and gas Phase Models\n\tActivate the discrete phase Model (Eulerian-Lagrangian)\n\tDefine the Liquid Phase as Tap Water\n\tInclude mass and momentum conservation equations for the liquid phase\n\tSet the turbulence model to Standard k-omega\n\tDefine the Gas Phase as Air\n\tUse Eulerian-Lagrangian model for the gas phase\n\nStep 3: Define Bubble Dynamics\n\tSet bubble size to 5 mm\n\tSet terminal rise velocity to 0.16 m/s\n\tDefine the number of bubbles as ranging from 300 to 5500\n\tInclude forces: drag, lift, virtual mass, gravity, and pressure forces on bubbles\n\nStep 4: Set Boundary Conditions\n\tSet liquid phase wall condition to no-slip\n\tSet bubble phase wall condition to reflect off walls\n\tSet gas velocity inlet at sparger inlet with superficial gas velocity of 0.16 m/s\n\nStep 5: Set Numerical Methods\n\tSet spatial discretization to Second-order QUICK scheme\n\tSet temporal discretization to First-order scheme \n\tStep 6: Run the steady state calculations for 5000 iterations.\n\nStep7: write the solution case and data file as 'bubble_column_model.cas.h5' and 'bubble_column_model.dat.h5'.".

Upon creation of the plurality of prompts, at step 316 of the method 300, the one or more hardware processors 104 are configured to generate the CAD file for the computational analysis of the industrial entity, using the geometry creation prompt, via the multimodal LLM. The steps for generating the CAD file comprises:

Feeding the geometry creation prompt to the multimodal LLM. If the geometry creation prompt is created based on one or more modified matched assumptions, the predefined fetching function is executed to load the CAD file directly from the predefined knowledge base, by the multimodal LLM. If the geometry creation prompt is created based on the one or more unmatched categorized assumptions, the steps for generating the CAD file comprises:

(i) Feeding the geometry creation prompt to the multimodal LLM, to generate the CAD script.

(ii) Executing the CAD script to generate a CAD model, by the CAD modeler.

(iii) Checking, via the multimodal LLM, if the created CAD model is compliant with the geometry creation information. If the created CAD model is compliant with the geometry creation information, the created CAD model is exported as the CAD file. If the created CAD model is not compliant with the geometry creation information, the CAD script is iteratively refined by feeding to the multimodal LLM along with a predefined CAD correction prompt until the created CAD model is compliant with the geometry creation information for exporting the created CAD model as the CAD file. The predefined CAD correction prompt comprises (a) a plurality of orthographic views of the generated CAD model with one or more-dimension labels, (b) a reference drawing of the CAD model, and (c) a plurality of instructions for the multimodal LLM to compare and correct the CAD script.

A sample predefined CAD correction prompt is provided as: "That's not quite right - the CAD of the part created using the CADQuery script you just gave me does not match the part shown in the original engineering drawing I provided you. The attached photo { 'bubble_column_top.png', bubble_column_side.png', 'bubble_column_front.png', 'bubble_column_back.png'} shows four views of the part's CAD that was created using the CadQuery script you just provided. Each view shows a different orientation of the CADed part, as seen by the coordinate system shown in each view. The views show the CADed part in a shaded-with-hidden-edges style. Based on these CAD views, can you update the CadQuery script to fix any issues that you see, so that the part created using the script matches the part shown in the original drawing I provided?".

The geometry creation prompt is fed to the multimodal LLM to generate the CAD script, which is executed by the CAD modeler to produce the CAD file. This CAD file undergoes analysis by the multimodal LLM to verify the geometry creation information. If the CAD file passes the inspection, it proceeds to the mesh generation. If inaccuracies are detected, it is returned to the multimodal LLM via the predefined CAD correction prompt.

Upon generating the CAD file, at step 318 of the method 300, the one or more hardware processors 104 are configured to generate the final mesh file for the computational analysis of the industrial entity, using the mesh creation prompt, and the generated CAD file, via the multimodal LLM. The steps for generating the final mesh file comprises:

Feeding the mesh creation prompt to the multimodal LLM. If the mesh creation prompt is created based on one or more modified matched assumptions, the predefined fetching function is executed to load the final mesh file directly from the predefined knowledge base.

If the mesh creation prompt is created based on the one or more unmatched categorized assumptions, the steps for generating the final mesh file comprises:

(i) Configuring a predefined meshing function based on the mesh creation prompt, by the multimodal LLM, to generate a configuration for the predefined meshing function, wherein the configuration for the predefined meshing function comprises a place holder for importing the CAD file, a predefined mesh size range, a plurality of system international (SI) unit choices, and a plurality of setup type choices. The plurality of SI unit choices comprises a plurality of predefined string values i.e., 'in', 'm', 'mm', 'μm' and the plurality of setup type choices comprises a plurality of predefined interger values choices i.e., 1 if geometry consist of solid regions, 0 if geometry only consist of fluid regions with no voids, 2 if geometry consists of only fluid and solid regions and/or voids.

(ii) Importing the generated CAD file into the predefined meshing function.

(iii) Executing the predefined meshing function, to obtain an initial mesh file along with a plurality of quality metrics. The plurality of quality metrics of the initial mesh file comprises a maximum threshold value of an aspect ratio that is 50, a minimum threshold value of a minimum orthogonal quality that is 0.1, and a maximum threshold value of skewness that is 0.85, according to some embodiments of the present disclosure.

(iv) Obtaining the final mesh file by comparing the plurality of quality metrics of the initial mesh file with a plurality of predefined threshold limits. If the plurality of quality metrics of the initial mesh file is not in compliance with the plurality of predefined threshold limits, then the predefined meshing function is iteratively reconfigured based on the plurality of predefined threshold limits, to generate the final mesh file.

The predefined meshing function is used for generating the final mesh file. In the predefined meshing function, initially the CAD file is imported. Further, local sizing is optionally applied to regions of the CAD model with steep gradients, such as sharp corners, edges, critical flow areas, that require refinement, followed by a specification of a predefined mesh size range to generate a surface mesh. Further domain information comprising whether the CAD model consists of solid regions, or only consist of fluid regions with no voids, or only fluid and solid regions with or without voids is specified, and a prismatic boundary layer is added near walls to ensure accurate boundary resolution. Finally, a volume mesh is generated, with options for polyhedral, poly-hexacore, or hexacore meshes, selected based on the complexity of flow and computational requirements.

The predefined meshing function requires several input parameters such as, name of the CAD file, the predefined mesh size range, the plurality of SI unit choices, and the domain information. These input parameters are predefined in a structured (eXtensible Markup Language) (XML) or JavaScript Object Notation (JSON)) format to clarify their functionalities. These predefined structured input parameter descriptions comprise (a) name of an input parameter, (b) data type of the input parameter (c) the natural language description of the functionality of the input parameter. The predefined meshing function is configured based on the mesh creation prompt, by the multimodal LLM. The mesh creation prompt, along with the predefined structured input parameter description is then passed to multimodal LLM. The multimodal LLM extracts the necessary input parameter values from the mesh creation prompt and input them into the predefined meshing function and executing it in the console by choosing the meshing function via function calling features of the multimodal LLM. The result is the mesh file, which the multimodal LLM compares the mesh quality with the plurality of predefined threshold limits (Minimum Orthogonal Quality > 0.1, Maximum Skewness < 0.85, Maximum Aspect Ratio <10, etc.) and iteratively change the configuration like (cell size, mesh type etc.) and is iteratively reconfigured based on the plurality of predefined threshold limits, to generate the final mesh file.

At step 320 of the method 300, the one or more hardware processors 104 are configured to generate the solver results file for the computational analysis of the industrial entity, using the solver setup script creation prompt, and the generated final mesh file, via the multimodal LLM. The steps for generating the solver results file comprises:

Feeding the solver setup script creation prompt to the multimodal LLM. If the solver setup script creation prompt is created based on one or more modified matched assumptions, the predefined fetching function is executed to load the solver results file directly from the predefined knowledge base. If the geometry creation prompt is created based on the one or more unmatched categorized assumptions, the steps for generating the solver results file comprises:

(i) Generating the solver setup script by feeding the solver setup script creation prompt to the multimodal LLM.

Executing the solver setup script by the multimodal LLM, to generate the solver results file. If any errors occur during the execution of the solver setup script, the solver setup script along with a predefined solver setup script correction prompt is passed to the multimodal LLM to iteratively correct the solver setup script and generate the solver results file. The solver setup script correction prompt comprises (a) a plurality of errors during execution of the solver setup script and (b) the plurality of instructions for the multimodal LLM to analyze the error and refine the solver setup script. An example of the predefined solver setup script correction prompt is provided as: "The code generated above is encountering the error : *{TypeError Traceback (most recent call last)Cell In[43], line* 1----> *1 olver. tui.define.boundary_conditions.perforated_walls() TypeError: 'TUIMenu' object is not callable}*, your task is to analyze the error and correct the parts of the code that are causing the error."

At step 322 of the method 300, the one or more hardware processors 104 are configured to generate the plurality of computational analysis result insights for the computational analysis of the industrial entity, using the computational analysis result insight prompt and the generated solver results file, via the multimodal LLM. The steps for generating the plurality of computational analysis result insights comprises:

Feeding the computational analysis result insight prompt to the multimodal LLM. If the computational analysis result insight prompt is created based on one or more modified matched assumptions, the predefined fetching function is executed to load the plurality of computational analysis result insights directly from the predefined knowledge base. If the computational analysis result insight prompt is created based on the one or more unmatched categorized assumptions, the steps for generating the plurality of computational analysis result insights comprises:

(a) Generating a postprocessing script by feeding the generated insights prompt to the multimodal LLM. The solver results file is imported by the generated postprocessing script.
(b) Executing the generated postprocessing script by the multimodal LLM, to generate the plurality of visualizations. If any error occurs during the execution of the generated postprocessing script, the generated postprocessing script along with a predefined postprocessing script correction prompt is passed to the multimodal LLM to iteratively correct the generated postprocessing script and generate the plurality of visualizations. The postprocessing script correction prompt comprises (a) the plurality of errors during execution of the postprocessing script (b) the plurality of instructions for the multimodal LLM to analyze the error and refine the postprocessing script. An example postprocessing script correction prompt: "The code generated above is encountering the error : *{ NameError: name 'pyfluent' is not defined occurs because the pyfluent module has not been imported or defined before calling its function. To fix this, ensure that import pyfluent is added at the beginning of your script.*}, your task is to analyze the error and correct the parts of the code that are causing the error."
Feeding a visualization prompt embedded with the plurality of visualizations to the multimodal LLM, to generate the plurality of computational analysis result insights for the computational analysis of the industrial entity. An example of the visualization prompt: "Assuming you are an expert in industrial computational analysis. Can you describe this image: {bubble_column_particletracks.png}?"

## Experimental Results

The method of the present disclosure has been demonstrated with the computational analysis of a bubble column using the multimodal LLM. The user would like to design a lab scale bubble column to study mixing at various velocities of an input air. The workflow started with the user providing the user input $u_1 \in U$ to the multimodal LLM. The $u_1 \in U$ is defined as follows:

$u_1$ = {I want to design a bubble column for my lab, and I want to improve interphase mixing from that column. } .

Here the user input was the natural language description. Since the user input does not contain information required for workflows of the computational analysis, the multimodal LLM would formulate the plurality of questions pertaining to the information required for various workflows. Let $Q_{req}$ be a question space comprising the geometry related question $Q_{geom}$, mesh configuration related question $Q_{mesh}$, solver setup related questions $Q_{NS}$ and postprocessing related questions $Q_{vis}$ represented as:

$$Q_{req} = Q_{geom} \cup Q_{mesh} \cup Q_{NS} \cup Q_{vis}$$

The plurality of questions was generated by the multimodal LLM, based on the user input. The plurality of questions $q \in Q_{req}$ generated by the multimodal LLM based on the missing information in the user input were displayed to the user in a chat-based interface as follows:

$q_1$ = *Do you have any existing designs or references that you'd like me to draw inspiration from?*
$u_2$ = *bubble _column_original.png*
$q_2$ = *what are the dimensions of various components in your geometry?*
$u_3$ = *I have a rectangular bubble column with (H,D, W) as (1.2, 0.2, 0.05) and a sparger represented by a rectangular patch of length of 0.18 and width of 0.06, located at the center of the bottom cross section*
$q_3$ = *what is the ratio of liquid height to the bubble column height.*
$u_4$ = *skips the question.*

The questions $q \in Q_{mesh}$ generated by the multimodal LLM to fetch mesh configuration information required for the mesh creation prompt as follows:

*$q_4$ = How many mesh configurations do you want to create?*
*$u_5$ = I want a fine and a coarse mesh*
*$q_5$ = what minimum or maximum cell size do you want to use?*
*$u_6$ = skips the question*
*$q_6$ = what are the different phases (solid, liquid, void, both, all), your geometry is made of?*
*$u_7$ = only liquid phase*
*$q_7$ = which SI unit do you want to choose for mesh creation?*
*$u_8$ = meters.*

The plurality of questions $q \in Q_{NS}$ generated by the multimodal LLM to fetch solver setup information required for the solver setup script creation prompt as follows:

*$q_9$ = what are your feed materials?*
*$u_{10}$ = water in the bubble column and air through the sparger.*
*$q_{10}$ = do you want to track bubble trajectory?*
*$u_{11}$ = yes*
*$q_{11}$ = what is the inlet velocity of air?*
*$u_{12}$ = 0.2 m/s*
*$q_{12}$ = what are the various governing equations that you want to solve?*
*$u_{13}$ = skips the question*
*$q_{13}$ = what numerical method do you want to use for discretization?*
*$u_{14}$ = skips the question*

The plurality of questions $q \in Q_{vis}$ generated by the multimodal LLM to fetch result visualization information required by the computational analysis result insight prompt as follows:

*$q_{14}$ = What are the various visualizations required from computational analysis?*
*$u_{14}$ = pressure and velocity magnitude contours, bubble trajectory plots and velocity vector plots.*
*$q_{15}$ = do you want to export the solution data in structured format like.cgns?*
*$u_{16}$ = No*

Further the plurality of questions is generated that are either
answered or skipped by the user. Based on the plurality of associated answers of the plurality of questions the multimodal LLM performs the first search and the second search using the RAG technique to retrieve more relevant information to bridge gap between the user input and information required for the computational analysis. The plurality of initial assumptions was as follows: *$q_{16}$ = Here are the plurality of initial assumptions based on the user input, the plurality of answers and retrieved information. Do you want to make any changes to the initial assumptions? Based on the information from user input and information in the article "Dynamics of gas-liquid flow in a rectangular bubble column: experiments and single/multi-group CFD simulations" retrieved from the knowledge bae. The simulation involves a rectangular bubble column with the following key details: \n\nColumn Geometry and Dimensions:\n- Width: 0.2 m\n-Height: 1.2 m\n- Depth: 0.05 m\n- Aerated Liquid Height to Column Width (H/W) Ratios: 2.25 and 4.5\n).\n- Gas Inlet Area: Total area covered by the sparger holes (18 x 6 mm). \n\nMeshing and Grid Configuration:\n- Grid Type: Non-uniform structured grids. \n- Coarse Grid: \n - For H/W ratio of 2.25: 15 x 25 x 5 cells. \n - For H/W ratio of 4.5: 15 x 46 x 5 cells. \n- Fine Grid:\n - For H/W ratio of 2.25: 29 x 50 x 11 cells. \n - For H/W ratio of 4.5: 29 x 92 x 11 cells. \n\ Governing Equations and Fluid Model: Method: Eulerian-Lagrangian approach, Liquid Phase: Mass and momentum conservation equations, Bubble Dynamics: Force balance equation including gravity, drag, lift, virtual mass, and pressure forces, Bubble Characteristics: Spherical bubbles with an average size of 5 mm, Bubble Rise Velocity: 0.20 m/s (terminal rise velocity), Number of Bubbles in Simulation: 300 to 5500, diameter of bubble: 5mm Turbulence Model: Standard k-$\omega$ turbulence model. \n Boundary Conditions: Walls: No-slip for liquid phase; bubbles reflect off walls, Sparger Inlet: Velocity inlet with gas velocity matching the terminal rise velocity (0.16m/s), Top Surface: Velocity inlet for gas, with normal liquid velocity set to zero. \n Solver Configuration: Software: ANSYS Fluent (version 6.1), Solver: Pressure-based solver, Time Stepping: steady with 5000 iterations, Discretization: Second-order QUICK scheme for spatial terms; first-order scheme for temporal derivatives. \n Operating Conditions: Gas Phase: Air, Liquid Phase: Tap water, Superficial Gas Velocity:0.16 cm/s. In Numerical Methods: Spatial Discretization: Second-order QUICK scheme, Temporal Discretization: First-order scheme, Time Step: 0.01 s. \n Validation and Results Validation and Results bubble plume dynamics, voidage, and gas hold-up profiles are visualized. \n This setup aims to replicate steady gas-liquid flow behavior in a rectangular bubble column.*
*$u_{17}$ = choose only H/W = 2.25 for further analysis, use k-w turbulence model and convert the mesh description from number of divisions to cell sizes.*

*q₁₇ = based on the corrections here is the revised version, do you want to make additional changes?*

*"Based on the information from user input and information in the article "Dynamics of gas-liquid flow in a rectangular bubble column: experiments and single/multi-group CFD simulations" retrieved from the knowledge bae. the simulation involves a rectangular bubble column with the following key details: \n Column Geometry and Dimensions: Width: 0.2 m, Height: 1.2 m, Depth: 0.05 m, Aerated Liquid Height to Column Width (H/W) Ratios: 2.25, Gas Inlet Area: Total area covered by the sparger holes (18 x 6 mm). \n Meshing and Grid Configuration: Grid Type: Non-uniform structured grids, Coarse Grid: For H/W ratio of 2.25: Min cell size: 0.01 m, Max cell size: 0.048 m, Fine Grid: For H/W ratio of 2.25: Min cell size: 0.01 m, Max cell size: 0.01333 m.\n Governing Equations and Fluid Model: Method: Eulerian-Lagrangian approach, Liquid Phase: Mass and momentum conservation equations, Bubble Dynamics: Force balance equation including gravity, drag, lift, virtual mass, and pressure forces, Bubble Characteristics: Spherical bubbles with an average size of 5 mm, Bubble Rise Velocity: 0.20 m/s (terminal rise velocity), Number of Bubbles in Simulation: 300 to 5500, diameter of bubble: 5mm, Turbulence Model: Standard k-ω turbulence model. \n Boundary Conditions: Walls: No-slip for liquid phase; bubbles reflect off walls, Sparger Inlet: Velocity inlet with gas velocity matching the terminal rise velocity (0.16m/s), Top Surface: Velocity inlet for gas, with normal liquid velocity set to zero. \n Solver Configuration: Software: ANSYS Fluent (version 6.1), Solver: Pressure-based solver, Time Stepping: steady with 5000 iterations, Discretization: Second-order QUICK scheme for spatial terms; first-order scheme for temporal derivatives. \n Operating Conditions: Gas Phase: Air, Liquid Phase: Tap water, Superficial Gas Velocity:0.16 cm/s. \n Numerical Methods: Spatial Discretization: Second-order QUICK scheme, Temporal Discretization: First-order scheme, \n Validation and Results bubble plume dynamics, voidage, and gas hold-up profiles are visualized. \n This setup aims to replicate steady gas-liquid flow behavior in a rectangular bubble column."*

The multimodal LLM generated the plurality of final assumptions based on the plurality of associated answers for the plurality of questions generated by the multimodal LLM, the user input, and the information extracted via the first search and the second search using the RAG technique. The plurality of final assumptions was generated as: *"Based on the information from user input and information in the article "Dynamics of gas-liquid flow in a rectangular bubble column: experiments and single/multi-group CFD simulations " retrieved from the knowledge bae. the simulation involves a rectangular bubble column with the following key details: \n Column Geometry and Dimensions: Width: 0.2 m, Height: 1.2 m, Depth: 0.05 m, Aerated Liquid Height to Column Width (H/W) Ratios: 2.25, Gas Inlet Area: Total area covered by the sparger holes (18 x 6 mm). \n Meshing and Grid Configuration: Grid Type: Non-uniform structured grids, Coarse Grid: For H/W ratio of 2.25: Min cell size: 0.01 m, Max cell size: 0.048 m, Fine Grid: For H/W ratio of 2.25: Min cell size: 0.01 m, Max cell size: 0.01333 m.\n \n Governing Equations and Fluid Model: Method: Eulerian-Lagrangian approach, Liquid Phase: Mass and momentum conservation equations, Bubble Dynamics: Force balance equation including gravity, drag, lift, virtual mass, and pressure forces, Bubble Characteristics: Spherical bubbles with an average size of 5 mm, Bubble Rise Velocity: 0.20 m/s (terminal rise velocity), Number of Bubbles in Simulation: 300 to 5500, Turbulence Model: Standard k-ω turbulence model. \n Boundary Conditions: Walls: No-slip for liquid phase; bubbles reflect off walls, Sparger Inlet: Velocity inlet with gas velocity matching the terminal rise velocity (0.20 m/s), Top Surface: Velocity inlet for gas, with normal liquid velocity set to zero. \n Solver Configuration: Software: ANSYS Fluent (version 6.1), Solver: Pressure-based solver, Time Stepping: steady with 5000 iterations, Discretization: Second-order QUICK scheme for spatial terms; first-order scheme for temporal derivatives. \n Operating Conditions: Gas Phase: Air, Liquid Phase: Tap water, Superficial Gas Velocity:0.16 cm/s \n Numerical Methods: Spatial Discretization: Second-order QUICK scheme, Temporal Discretization: First-order scheme\n Validation and Results: bubble plume dynamics, voidage, and gas hold-up profiles. ".*

The plurality of final assumptions was categorized into the plurality of current categorized assumptions comprising the plurality of current geometry assumptions, the plurality of current mesh assumptions, the plurality of current solver setup assumptions, and the plurality of current computational analysis result insight assumptions, based on the plurality of workflows of the computational analysis of the industrial entity. The plurality of current categorized assumptions involved a rectangular bubble column with the following key details: \n Column Geometry and Dimensions: Width: 0.2 m, Height: 1.2 m, Depth: 0.05 m, Aerated Liquid Height to Column Width (H/W) Ratios: 2.25, Gas Inlet Area: Total area covered by the sparger holes (18 x 6 mm). The plurality of current mesh assumptions was Meshing and Grid Configuration: Grid Type: Non-uniform structured grids, Coarse Grid: For H/W ratio of 2.25: Min cell size: 0.01 m, Max cell size: 0.048 m, Fine Grid: For H/W ratio of 2.25: Min cell size: 0.01 m, Max cell size: 0.01333 m. The plurality of current solver setup assumptions were Governing Equations and Fluid Model: Method: Eulerian-Lagrangian approach, Liquid Phase: Mass and momentum conservation equations, Bubble Dynamics: Force balance equation including gravity, drag, lift, virtual mass, and pressure forces, Bubble Characteristics: Spherical bubbles with an average size of 5 mm, Bubble Rise Velocity: 0.16 m/s (terminal rise velocity), Number of Bubbles in Simulation: 300 to 5500, Turbulence Model: Standard k-ω turbulence model. \n Boundary Conditions: Walls: No-slip for liquid phase; bubbles reflect off walls, Sparger Inlet: Velocity inlet with gas velocity matching the terminal rise velocity (0.16 m/s), Top Surface: Velocity inlet for gas, with normal liquid velocity set to zero. \n Solver Configuration: Software: ANSYS Fluent (version 6.1), Solver: Pressure-based solver, Time Stepping: steady with 5000 iterations, Discretization: Second-order QUICK scheme for spatial terms; first-order scheme for temporal derivatives. \n Operating Conditions: Gas Phase: Air, Liquid Phase: Tap water, Superficial Gas Velocity: 0.16 cm/s The plurality of current computational analysis result insight assumptions includes bubble plume dynamics and gas hold-up profiles.

The plurality of existing categorized assumptions was compared with the plurality of current categorized assumptions to obtain an exact match. However, for this example the plurality of existing categorized assumptions did not match with the plurality of current categorized assumptions. So, no modifications were applied.

The CAD script was generated using the geometry creation prompt and the CAD script was executed to generate the CAD model by the CAD modeler. The geometry creation prompt was created by the multimodal LLM as "Taking the given description and schematic attached as image {bubble_column_original.png} into context generate a CADQuery script for CAD model creation. The geometry consists of a rectangular bubble column with dimensions: width = 0.2 m, height = 1.2 m, and depth = 0.05 m. Include a rectangular pitch of width 18mm and height 6mm at the center of the bottom cross-section of the bubble column lying horizontally Generate the model script and export it to 'bubble_column_model.step'."

The output of the multimodal LLM was : (Initial CADQuery Script): "import cadquery as cq\nwidth = 0.2 # Width of the bubble column in meters\nheight = 1.2 # Height of the bubble column in meters\ndepth = 0.05 # Depth of the bubble column in meters\npitch_width = 0.006 # Width of the pitch in meters\npitch_height = 0.018 # Height of the pitch in meters \nbubble_column = (cq.Workplane("XY").box(width, depth, height, centered=(True, True, False)))\npitch = (cq.Workplane("XY").center(0, 0).rect(pitch_width, pitch_height). cutThruAll())\nbubble_column_with_pitch = bubble_column.cut(pitch)\ncq.exporters.export(bubble_column_with_pitch, "bubble_column_model.step")".

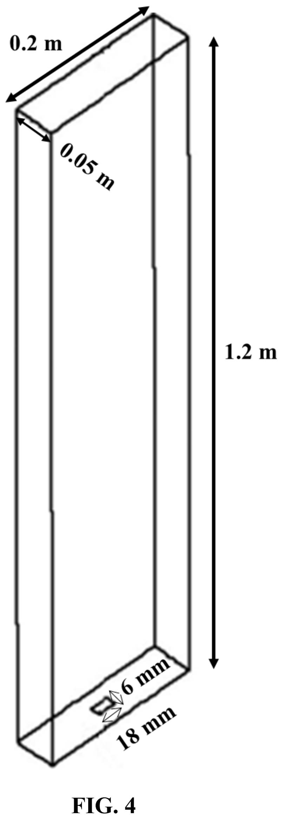

The generated CAD script above encountered any error, the task was to analyze the error and correct the parts of the CAD script that are causing the error. A refined CAD script that was generated by the multi model LLM as follows: "import cadquery as cq\nwidth = 0.2 # Width of the bubble column in meters\nheight = 1.2 # Height of the bubble column in meters\ndepth = 0.05 # Depth of the bubble column in meters\npitch_width = 0.018 # Width of the pitch in meters \npitch_height = 0.006 # Height of the pitch in meters\nbubble_column = (cq.Workplane("XY").box(width, depth, height, centered=(True, True, False)))\nbubble_column_with_pitch = (bubble_column.faces(">Z").workplane(centerOption="-CenterOfBoundBox").rect(pitch_width, pitch_height).extrude(0.0001))\ncq.exporters.export (bubble_column_with_pitch, "bubble_column_model.step")". The output of the multimodel LLM was the CAD file "bubble_column_model.step". FIG. 4 depicts a CAD model obtained by executing the CAD script, according to some embodiments of the present disclosure. More specifically FIG. 4 represents the CAD model of a rectangular bubble column 0.2 m width, 1.2 m height and 0.05m depth with a rectangular sparger of width 18mm and depth 6mm at the center of the bottom cross-section.

The mesh creation prompt was created by the multimodal LLM as "the geometry filename is 'bubble_column_model.step'. Here is the input description for mesh generation: setup type: 0, Cell sizes: Coarse mesh: Min cell size: 0.01 m, Max cell size: 0.048 m, Fine mesh: Min cell size: 0.01 m, Max cell size: 0.01333 m; All cell sizes are in meters (m) Export the mesh as 'bubble_column_model.msh'".

The predefined meshing function is as follows:

```
# define input schema
class MeshInput(BaseModel):
  geom_name: str = Field(..., description
          = "name of the CAD file to be imported")
  min_size: float = Field(..., description
          = "Minimum grid size defined in the paper")
  max_size: float = Field(..., description
          = "Maximum grid size defined in the paper")
  setup_type: int = Field(..., description
          = "1 if geometry only consist of solid regions\
,0 if geometry only consist of fluid regions with no voids, 2 if geometry consists of only \
  fluid and solid regions and/or voids")
  unit: str = Field(..., description
= "can be one of the four choices 'in', 'm', 'mm', 'µm' as described in the paper").
```

The predefined meshing function configured based on the mesh creation prompt as follows:

```
"#multimodel llm executes the predefined Meshing function for coarse grid
geom_name = "bubble_column_model.step"
min_size = 0.01
max_size = 0.048
setup_type = 0
unit = m
#agent calling the meshing function
Meshing (geom_name, min_size, max_size, setup_type, unit)"
"# llm agent executes Meshing function for fine grid
geom_name = "bubble_column_model.step"
min_size = 0.01
max_size = 0.0133
setup_type = 0
unit = m
#agent calling the predefined meshing function
Meshing (geom_name, min_size, max_size, setup_type, unit)"
```

The predefined meshing function was executed to obtain the initial mesh file along with the plurality of quality metrics. The final mesh file was obtained by comparing the plurality of quality metrics of the initial mesh file with the plurality of predefined threshold limits. The plurality of quality metrics was defined as follows:

$$[Quality\ Measure:\ Orthogonal\ Quality]$$

$$19555\ cells\ were\ created\ in:\ 0.05\ minutes$$

$$The\ mesh\ has\ a\ minimum\ Orthogonal\ Quality\ of: \mathbf{0.21}$$

$$The\ volume\ meshing\ of\ bubble\_column\_model\ is\ complete.$$

$$Diagnostics\ Scope:\ 1\ Objects, 4\ Face\ Zones, 2\ Cell\ Zones$$

$$Objects:\ (design1)$$

$$Surface\ Diagnostics:$$

$$Total\ Number\ of\ Faces\ =\ 3614$$

$$Maximum\ Skewness\ =\ 0.6363$$

$$Maximum\ Aspect\ Ratio\ =\ 17.08$$

$$Volume\ Diagnostics:$$

$$Total\ Number\ of\ Cells\ =\ 19555$$

$$Minimum\ Orthogonal\ Quality\ =\ 0.2063$$

$$Maximum\ Aspect\ Ratio\ =\ 30.43$$

$$Number\ of\ Isolated\ Cells\ =\ 0$$

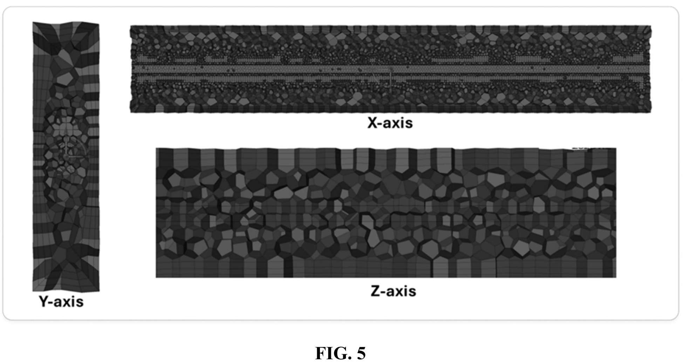

The plurality of predefined threshold limits was defined as Maximum Aspect ratio < 50, Minimum Orthogonal Quality > 0.1, and Maximum Skewness < 0.85. The plurality of quality metrics of the initial mesh file was compared with the plurality of predefined threshold limits by the multimodal LLM to obtain the final mesh file as depicted in FIG. 5. More specifically FIG. 5 represents XY, YZ and ZX cross sectional views of a Polyhexcore mesh.

The solver setup script creation prompt was fed to the multimodal LLM to generate the solver setup script. The solver setup script creation prompt was created as "write pyfluent settings api commands for the following query: Step 1: Initialize the Solver Settings\n\tStart ANSYS Fluent and select the Pressure-based solver\n\tSet Time Stepping to steady \n\nImport the mesh file named "bubble_column_model.msh" and rescale it to meters. Step 2: Define the Fluid and gas Phase Models\n\tActivate the discrete phase Model (Eulerian-Lagrangian)\n\tDefine the Liquid Phase as Tap Water\n \tInclude mass and momentum conservation equations for the liquid phase\n\tSet the turbulence model to Standard k-omega\n\tDefine the Gas Phase as Air\n\tUse Eulerian-Lagrangian model for the gas phase\n\nStep 3: Define Bubble Dynamics\n\tSet bubble size to 5 mm\n\tSet terminal rise velocity to 0.16 m/s\n\tDefine the number of bubbles as ranging from 300 to 5500\n\tInclude forces: drag, lift, virtual mass, gravity, and pressure forces on bubbles\n\nStep 4: Set Boundary Conditions\n\tSet liquid phase wall condition to no-slip\n\tSet bubble phase wall condition to reflect off walls\n \tSet gas velocity inlet at sparger inlet with superficial gas velocity of 0.16 m/s\n\nStep 5: Set Numerical Methods\n\tSet spatial discretization to Second-order QUICK scheme\n\tSet temporal discretization to First-order scheme \n\tStep 6: Run the steady state calculations for 5000 iterations.\n\nStep7: write the solution case and data file as 'bubble_column_model.cas.h5' and 'bubble_column_model.dat.h5'."

The output of the multimodal LLM for the solver setup script creation prompt was:

```
solver = pyfluent.launch_fluent (version='3d', precision='double',
processor _count=4, mode="solver",
show_gui=True)\nsolver.file.read_mesh(file_name="bubble_column_model.
msh")\nsolver.tui.mesh.check()\nsolver.tui.define.units('length',
'm')\nsolver.setup.general.solver.type = 'pressure-
based'\nsolver.setup.general.solver.time =
'steady'\nsolver.setup.general.solver.velocity_formulation =
'absolute'\nsolver. setup. general. operating_conditions. gravity. enable =
True\nsolver. setup. general. operating _conditions.gravity.components = [0, 0,
9.8065]\nsolver.setup.models.viscous.model = 'k-
omega'\nsolver. tui.define.materials. copy('fluid', 'water-
liquid')\nsolver.tui.define.phases.phase_domain("phase-1", "material", "yes",
"air")\nsolver.tui.define.phases.phase_domain("phase-2", "material", "yes",
"water-
liquid")\nsolver.tui.define.phases.set_domain_properties.change_phases_nam
es("phase-2", 'phase-
1")\nsolver.tui.define.phases.set_domain_properties.interaction_domain.forces
.drag.drag_coeff("yes", "constant",
"0.47")\nsolver.tui.define.phases.set_domain_properties.interaction_domain.f
orces.drag.drag_modeling("yes")\nsolver.tui.define.phases.set_domain_proper
ties.interaction_domain.forces.drag.drag_model_type("quadratic")\nsolver.tui.
define.phases.set_domain_properties.interaction_domain.forces.lift.lift_force(
"yes")\nsolver.tui.define.phases.set_domain_properties.interaction_domain.fo
rces.lift.lift_coeff("yes", "constant",
"0.5")\nsolver.tui.define.phases.set_domain_properties.interaction_domain.for
ces.virtual_mass.vm_coeff("yes", "constant",
"1.0")\nsolver.tui.define.phases.set_domain_properties.interaction_domain.for
ces.virtual_mass.vm_modeling("yes")\nsolver.tui.define.phases.set_domain_p
roperties.interaction_domain.forces.pressure.pressure_force("yes")\nsolver.tui
.define.phases.set_domain_properties.interaction_domain.forces.pressure.pres
sure_coeff("yes", "constant", "1.0")\ndpm_general =
solver.setup.models.discrete_phase.general_settings\ndpm_general.contour_pl
otting_option = 'none'\ndpm_general.interaction.option =
'coupled'\ndpm_general.interaction.source _update_every_iteration_enabled =
False\ndpm_general.interaction.iteration_interval =
5\ndpm_general.unsteady_tracking.option = 'dpm-time-
step'\ndpm_general.unsteady_tracking.dpm_time_step =
0.005\ndpm_general.unsteady _tracking.n_time_steps =
1\nsolver.setup.models.discrete_phase.tracking.tracking_parameters.max_nu
mber_of_steps =
2000\nsolver.setup.models.discrete_phase.tracking.high_res_tracking_enable
d = True\ninject_0 = solver.setup.models.discrete_phase.injections['injection-
0']\ninject_0.injection_type.option = 'bubble'\ninject_0.number_of_streams =
10\ninject_0.particle_type = 'inert'\ninject_0.material =
'air'\ninject_ 0.initial_props.particle_size.option =
'constant'\ninject_0.initial_props.location = {'x': 0.0, 'y': 0.0, 'z':
1.2}\ninject_0.initial_props.times = {'start_time': 0, 'stop_time':
1000}\ninject_0.initial_props.velocity.magnitude =
0.20\ninject_0.initial_props.particle_size.rosin_rammler_settings =
{'min_diam': 4e-06, 'max_diam': 6e-05, 'mean_diam': 4e-05, 'spread': 3.5,
'number_of_diameters':
10}\ninject_ 0.physical_models.turbulent_dispersion.option = 'discrete-
random-walk'\nfluidzone =
solver.setup.cell_zone_conditions.fluid['fluid_zone']\nfluidzone.porous =
False\nfluidzone.laminar = False\nfluidzone.direction_1_x,
fluidzone.direction_1_y, fluidzone.direction_1_z = 0, 0,
1\nfluidzone.direction_2_x, fluidzone.direction_2_y, fluidzone.direction_2_z
= 0, 1, 0\nwall1 = solver. setup. boundary_conditions.wall['wall_ext-
fluid_zone']\nwall1.material = 'steel'\nwall1.thermal_bc =
'Convection'\nwall1.tinf.value = '-30 [C]'\nwall1.h.value =
10\nwall1.planar_conduction = True\nwall1.dpm_bc_type = 'wall-
film'\nwall1.dpm_wall_heat_exchange =
True\nwall1.dpm_impingement_splashing_model = 'stochastic
kuhnke'\ninletbc =
solver.setup.boundary_conditions.velocity_inlet['inlet']\nmixbc =
inletbc.phase['mixture']\nmixbc.vmag.value =
0.20\nsolver.solution.methods.p_v_coupling.flow_scheme =
'SIMPLE'\nsolver.solution.methods.flux_type.pbns_cases. flux_auto_select =
True\nsolver.solution.methods.discretization_scheme = {'pressure':
'PRESTO', 'omega': 'second-order-upwind', 'k': 'second-order-upwind', 'mom':
'QUICK'}\nsolver.solution.initialization.initialization_type =
'hybrid'\nsolver.solution.initialization.initialize()\nsolver.solution.run_calculat
ion.iter_count =
2000\nsolver.solution.run_calculation.iterate()\nsolver.file.confirm_overwrite
= True\nsolver.file.write(file_name="bubble_column_model.cas.h5",
data_name="bubble_column_model.dat")\nsolver.exit()
```

The solver setup script was executed by the multimodal LLM, to generate the solver results file. The multimodal LLM had shown error during executing the solver setup script as follows:

$NameError \qquad Traceback\ (most\ recent\ call\ last)$

$Cell\ In[1], line\ 2$

$\qquad 1 \qquad launch\ ANSYS\ FLuent\ in\ solver\ mode\ with\ double\ precision,$

$4\ processor\ count, 2d\ mode\ and\ showing\ the\ gui$

$----> 2\ solver\ =\ pyfluent.launch\_fluent(version = '3d', precision$

$= "double", processor\_count = 4, mode$

$= "solver", show\_gui = True)$

$NameError: name\ 'pyfluent'\ is\ not\ defined$

The solver setup script along with the predefined solver setup script correction prompt was passed to the multimodal LLM to iteratively correct the solver setup script to include an error causing line "import ansys.fluent.core as pyfluent", and the solver results file was generated. An example of the solver result file is bubble _column_model.cas.h5; bubble _column_model.dat.h5.

The postprocessing script was generated by feeding the generated computational analysis result insight prompt ""Create the following visualization of bubble plume dynamics by creating a velocity contour plot, visualization of gas holdup profile by plotting contours of volume fraction of inlet air plume, visualization of trajectory of bubbles by creating a particle tracking plot", to the multimodal LLM. The solver results file was imported by the generated postprocessing script.

The output of the multimodal LLM for the computational analysis result insight prompt was:

```
fluent = pyfluent.launch _fluent()\ncase_file =
'bubble_column_model.cas.h5'\ndata_file =
'bubble_column_model.dat.h5'\nfluent.file.read_case_data(case_file,
data_file)\nfluent.solution.monitors.particle_tracks.setup(\n
tracking_method='continuous',\n injection_type='uniform',\n
particle _density=1.0,\n particle _size=0.05,\n
number_of_particles=1000\n)\nfluent.display.contours.create(\n
variable='phase_fraction(gas)',\n surfaces='slices',\n color_map='jet',\n
levels=10\n)\nfluent.display.contours.create(\n variable='gas_hold_up',\n
surfaces='slices',\n color_map='rainbow',\n
levels=10\n)\nfluent.display.vectors.create(\n variable='velocity',\n
phase='gas',\n surfaces='slices',\n
vector_density=5\n)\nfluent.display.save_picture('bubble_plume.png',
format='png')\nfluent. display. save_picture('voidage_profile.png',
format='png')\nfluent. display. save_picture('gas_holdup_profile.png',
format='png')\nfluent.file.export_data('gas_hold_up_data.csv',
variables=['gas_hold_up', 'x', 'y',
'z'])\nfluent.file.export_data('voidage_data.csv',
variables=['phase_fraction(gas)', 'x', 'y',
'z'])\nfluent.exit()\nprint(" Visualization and data export complete.")
```

The generated postprocessing script was executed by the multimodal LLM.. The multimodal LLM had shown error during executing the postprocessing script as follows:

$NameError \qquad Traceback\ (most\ recent\ call\ last)$

$Cell\ In[1], line\ 2$

$\qquad 1\ Q. How\ to\ launch\ ANSYS\ FLuent\ in\ solver\ mode\ with\ double\ precision,$

$$4\ processor\ count, 2d\ mode\ and\ showing\ the\ gui$$

$$----> 2\ solver\ =\ pyfluent.launch\_fluent(version\ =\ '3d', precision$$

$$=\ "double", processor\_count\ =\ 4, mode$$

$$=\ "solver", show\_gui\ =\ True)$$

$$NameError: name\ 'pyfluent'\ is\ not\ defined$$

The multimodal LLM analyzes the error and correct the parts of the postprocessing script that are causing the error. The corrected postprocessing script is as follows:

```
Import pyfluent\nfluent = pyfluent.launch _fluent()\ncase_file =
'bubble_column_model.cas.h5'\ndata_file =
'bubble_column_model.dat.h5'\nfluent.file.read_case_data(case_file,
data_file)\nfluent.solution.monitors.particle_tracks.setup(\n
tracking_method='continuous',\n injection_type='uniform',\n particle _density=1.0,\n
particle _size=0.05,\n number_of_particles=1000\n)\nfluent.display.contours.create(\n
variable='phase_fraction(gas)',\n surfaces='slices',\n color_map='jet',\n
levels=10\n)\nfluent.display.contours.create(\n variable='gas_hold _up',\n
surfaces='slices',\n color_map='rainbow',\n
levels=10\n)\nfluent.display.vectors.create(\n variable='velocity',\n phase='gas',\n
surfaces='slices',\n
vector_density=5\n)\nfluent.display.save_picture('bubble_plume.png',
format='png')\nfluent.display.save_picture('voidage_profile.png',
format='png')\nfluent.display.save_picture('gas_holdup_profile.png',
format='png')\nfluent.file.export_data('gas_hold_up_data.csv',
variables=['gas_hold_up', 'x', 'y', 'z'])\nfluent.file.export_data('voidage_data.csv',
variables=['phase_fraction(gas)', 'x', 'y', 'z'])\nfluent.exit()\nprint(" Visualization and
data export complete. ")
```

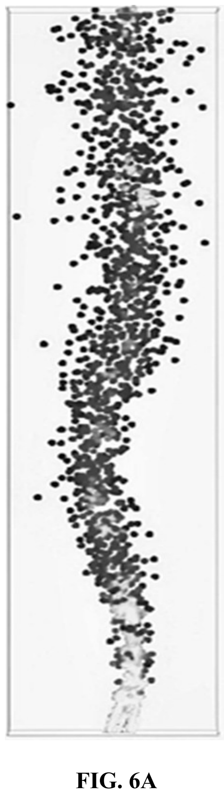

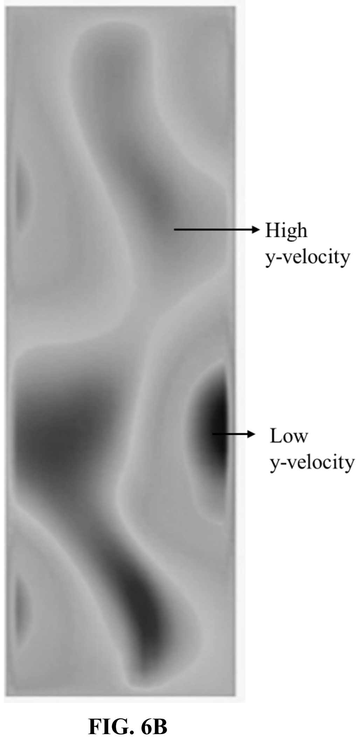

The corrected post-processing script is executed to generate the plurality of visualizations as output depicted in FIGS. 6A, and 6B, according to some embodiments of the present disclosure. The visualization prompt embedded with the plurality of visualizations was fed to the multimodal LLM, to generate the plurality of computational analysis result insights. More specifically FIG. 6A represents uniform contours of particle concentration in kg/m$^3$, ranging from 0 represented in black to 0.0107 represented in white color at 0.16 cm/s inlet air velocity across the height of the rectangular bubble column. More specifically FIG. 6B represents uniform contours of y-velocity in cm/s, with dark shades indicating higher and lower y-velocity ranges and lighter shades representing intermediate values, are shown at an inlet air velocity of 0.16 cm/s across the height of the rectangular bubble column. In the y-velocity, y represent y component of the velocity.

Using a motivating example of the bubble column, the method of the present disclosure reduced costs by minimizing reliance on specialized expertise. It automates complex tasks such as generating the CAD file, the final mesh file, the solver results file, and the plurality of computational analysis result insights, while consolidating multiple tools into a single approach, thereby reducing software expenses and training expenses. Features like advanced planning, reusing outputs from a knowledge base for similar queries, seamless integration of tasks, and automation accelerate the process by eliminating delays from manual iterations and tool-switching. Additionally, the method of present disclosure significantly reduces user involvement by streamlining user experience, simplifying configurations, and making the workflow more accessible to non-experts, reducing the cognitive and labor-intensive demands typically associated with complex computational analysis. Together the method of the present disclosure significantly improves the efficiency of the process in terms of cost, time, and effort.

The written description describes the subject matter herein to enable any person skilled in the art to make and use the embodiments. The scope of the subject matter embodiments is defined by the claims and may include other modifications that occur to those skilled in the art. Such other modifications are intended to be within the scope of the claims if they have similar elements that do not differ from the literal language of the claims or if they include equivalent elements with insubstantial differences from the literal language of the claims.

The embodiments of the present disclosure herein address the unresolved problem of automating complex computational analysis tasks in a flexible and intuitive manner, especially for users with varying levels of expertise. The embodiment, thus, provides a novel framework that integrates multimodal inputs, advanced planning, and real-time information retrieval to reduce errors and enhance the accuracy of outputs. Moreover, the embodiments herein further provide a modular agentic workflow capable of interacting with multiple meshing tools, CAD generation tools, and solvers, enabling seamless integration across different software platforms and overcoming the limitations of existing solutions that rely on specific software or require extensive user involvement for task execution and correction.

It is to be understood that the scope of the protection is extended to such a program and in addition to a computer-readable means having a message therein; such computer-readable storage means contain program-code means for implementation of one or more steps of the method, when the program runs on a server or mobile device or any suitable programmable device. The hardware device can be any kind of device which can be programmed including e.g., any kind of computer like a server or a personal computer, or the like, or any combination thereof. The device may also include means which could be e.g., hardware means like e.g., an application-specific integrated circuit (ASIC), a field-programmable gate array (FPGA), or a combination of hardware and software means, e.g., an ASIC and an FPGA, or at least one microprocessor and at least one memory with software processing components located therein. Thus, the means can include both hardware means and software means. The method embodiments described herein could be implemented in hardware and software. The device may also include software means. Alternatively, the embodiments may be implemented on different hardware devices, e.g., using a plurality of CPUs.

The embodiments herein can comprise hardware and software elements. The embodiments that are implemented in software include but are not limited to, firmware, resident software, microcode, etc. The functions performed by various components described herein may be implemented in other components or combinations of other components. For the purposes of this description, a computer-usable or computer readable medium can be any apparatus that can comprise, store, communicate, propagate, or transport the program for use by or in connection with the instruction execution system, apparatus, or device.

The illustrated steps are set out to explain the exemplary embodiments shown, and it should be anticipated that ongoing technological development will change the manner in which particular functions are performed. These examples are presented herein for purposes of illustration, and not limitation. Further, the boundaries of the functional building blocks have been arbitrarily defined herein for the convenience of the description. Alternative boundaries can be defined so long as the specified functions and relationships thereof are appropriately performed. Alternatives (including equivalents, extensions, variations, deviations, etc., of those described herein) will be apparent to persons skilled in the relevant art(s) based on the teachings contained herein. Such alternatives fall within the scope of the disclosed embodiments. Also, the words "comprising," "having," "containing," and "including," and other similar forms are intended to be equivalent in meaning and be open ended in that an item or items following any one of these words is not meant to be an exhaustive listing of such item or items, or meant to be limited to only the listed item or items. It must also be noted that as used herein and in the appended claims, the singular forms "a," "an," and "the" include plural references unless the context clearly dictates otherwise.

Furthermore, one or more computer-readable storage media may be utilized in implementing embodiments consistent with the present disclosure. A computer-readable storage medium refers to any type of physical memory on which information or data readable by a processor may be stored. Thus, a computer-readable storage medium may store instructions for execution by one or more processors, including instructions for causing the processor(s) to perform steps or stages consistent with the embodiments described herein. The term "computer-readable medium" should be understood to include tangible items and exclude carrier waves and transient signals, i.e., be non-transitory. Examples include random access memory (RAM), read-only memory (ROM), volatile memory, nonvolatile memory, hard drives, CD ROMs, DVDs, flash drives, disks, and any other known physical storage media.

It is intended that the disclosure and examples be considered as exemplary only, with a true scope of disclosed embodiments being indicated by the following claims.

## Claims

1. A processor implemented method (300), the method comprising:

receiving (302), via one or more hardware processors, a user input comprising at least one of (a) one or more information documents, (b) a technical problem description, (c) a natural language description, (d) a reference engineering drawing, and (e) a plurality of web resources pertaining to a computational analysis of an industrial entity;

generating (304), via the one or more hardware processors, a plurality of questions, by a multimodal Large Language Model (LLM), based on the user input, wherein the plurality of questions pertains to a computational analysis information required by a plurality of workflows of the computational analysis of the industrial entity, and wherein the computational analysis information of the plurality of workflows comprises a geometry creation information, a mesh related information, a solver setup related information, and a postprocessing information;

generating (306), via the one or more hardware processors, a plurality of final assumptions, by the multimodal LLM, based on (i) a plurality of associated answers for the plurality of questions generated by the multimodal LLM, (ii) the user input , and (iii) an information extracted via a first search and a second search using a Retrieval-Augmented Generation (RAG) technique, wherein the information extracted via the first search and the second search comprises a set of answers for a set of skipped questions among the plurality of questions;

categorizing (308), via the one or more hardware processors, the plurality of final assumptions into a plurality of current categorized assumptions comprising a plurality of current geometry assumptions, a plurality of current mesh assumptions, a plurality of current solver setup assumptions, and a plurality of current computational analysis result insight assumptions, based on the plurality of workflows of the computational analysis of the industrial entity;

extracting (310), via the one or more hardware processors, a plurality of existing categorized assumptions based on the plurality of current categorized assumptions by the first search using the RAG technique, wherein the existing categorized assumptions comprises (i) a plurality of existing geometry assumptions, (ii) a plurality of existing mesh assumptions, (iii) a plurality of existing solver setup assumptions, and (iv) a plurality of existing computational analysis result insight assumptions in the knowledge base;

identifying (312), via the one or more hardware processors, one or more matched categorized assumptions, and one or more unmatched categorized assumptions by comparing the plurality of current categorized assumptions with the plurality of existing categorized assumptions, wherein if one or more current categorized assumptions of the plurality of current categorized assumptions is exactly matching with one or more existing categorized assumptions of the plurality of existing categorized assumptions, the one or more matched categorized assumptions are replaced with a set of instructions to enable the multimodal LLM for executing a predefined fetching function, by the multimodal LLM, to generate one or more modified matched assumptions;

creating (314), via the one or more hardware processors, a plurality of prompts comprising (i) a geometry creation prompt, (ii) a mesh creation prompt, (iii) a solver setup script creation prompt, (iv) and a computational analysis result insight prompt, by the multimodal LLM, based on the one or more modified matched assumptions, and the one or more unmatched categorized assumptions;

generating (316), via the one or more hardware processors, a Computer-Aided Design (CAD) file for the computational analysis of the industrial entity, using the geometry creation prompt, via the multimodal LLM;

generating (318), via the one or more hardware processors, a final mesh file for the computational analysis of the industrial entity, using the mesh creation prompt, and the generated CAD file, via the multimodal LLM;

generating (320), via the one or more hardware processors, a solver results file for the computational analysis of the industrial entity, using the solver setup script creation prompt, and the generated final mesh file, via the multimodal LLM; and

generating (322), via the one or more hardware processors, a plurality of computational analysis result insights for the computational analysis of the industrial entity, using the computational analysis result insight prompt and the generated solver results file, via the multimodal LLM.

2. The processor implemented method as claimed in claim 1, wherein the steps for generating the plurality of final assumptions, by the multimodal LLM, using the Retrieval-Augmented Generation (RAG) technique comprises:

performing the first search and the second search on the user input and the plurality of associated answers for the plurality of questions generated, by the multimodal LLM, using the RAG technique, to obtain a missing information required by the plurality of workflows of the computational analysis; and

generating a plurality of initial assumptions serving as the plurality of final assumptions based on one of (i) an acceptance confirmation by a user, and (ii) one or more associated modifications applied to the plurality of initial assumptions, by the multimodal LLM;

3. The processor implemented method of claim 1, wherein the knowledge base search is performed on the predefined knowledge base, wherein the predefined knowledge base comprises at least one of (a) a plurality of structured resources, and (b) a plurality of unstructured resources related to the computational analysis of the an industrial entity, comprising a plurality of predefined knowledge base entries, and wherein the plurality of predefined knowledge base entries comprises an information source metadata, the technical problem description, a plurality of geometry assumptions, a CAD script, the CAD file, a plurality of mesh assumptions, a plurality of mesh configurations, the final mesh file, a plurality of solver setup assumptions, a solver setup script, the solver results file, a plurality of computational analysis result insight assumptions, a post-processing script, a plurality of visualizations, and the plurality of computational analysis result insights.

4. The processor implemented method as claimed in claim 1, wherein the steps for generating the CAD file comprises: feeding the geometry creation prompt to the multimodal LLM,

wherein if the geometry creation prompt is created based on one or more modified matched assumptions, the predefined fetching function is executed to load the CAD file directly from the predefined knowledge base; and

wherein if the geometry creation prompt is created based on the one or more unmatched categorized assumptions, the steps for generating the CAD file comprises:

feeding the geometry creation prompt to the multimodal LLM, to generate the CAD script;
executing the CAD script to generate a CAD model, by a CAD modeler; and
checking, via the multimodal LLM, if the created CAD model is compliant with the geometry creation information, wherein if the created CAD model is compliant with the geometry creation information, the created CAD model is exported as the CAD file, wherein if the created CAD model is not compliant with the geometry creation information, the CAD script is iteratively refined by feeding to the multimodal LLM along with a predefined CAD correction prompt until the created CAD model is compliant with the geometry creation information for exporting the created CAD model as the CAD file, and wherein the predefined CAD correction prompt comprises (a) a plurality of orthographic views of the generated CAD model with one or more dimension labels, (b) the reference engineering drawing of the CAD model, and (c) a plurality of instructions for the multimodal LLM to compare and correct the CAD script.

5. The processor implemented method as claimed in claim 1, wherein the steps for generating the final mesh file comprises:
feeding the mesh creation prompt to the multimodal LLM,

wherein if the mesh creation prompt is created based on one or more modified matched assumptions, the predefined fetching function is executed to load the final mesh file directly from the predefined knowledge base; and
wherein if the mesh creation prompt is created based on the one or more unmatched categorized assumptions, the steps for generating the final mesh file comprises:

configuring a predefined meshing function based on the mesh creation prompt, by the multimodal LLM, to generate a configuration for the predefined meshing function, wherein the configuration for the predefined meshing function comprises a place holder for importing the CAD file, a predefined mesh size range, a plurality of system international (SI) unit choices, and a plurality of setup type choices; importing the generated CAD file into the predefined meshing function; executing the predefined meshing function, to obtain an initial mesh file along with a plurality of quality metrics; and
obtaining the final mesh file by comparing the plurality of quality metrics of the initial mesh file with a plurality of predefined threshold limits, wherein if the plurality of quality metrics of the initial mesh file is not in compliance with the plurality of predefined threshold limits, then the predefined meshing function is iteratively reconfigured based on the plurality of predefined threshold limits, to generate the final mesh file.

6. The processor implemented method as claimed in claim 1, wherein the steps for generating the solver results file comprises:
feeding the solver setup script creation prompt to the multimodal LLM,

wherein if the solver setup script creation prompt is created based on one or more modified matched assumptions, the predefined fetching function is executed to load the solver results file directly from the predefined knowledge base; and
wherein if the geometry creation prompt is created based on the one or more unmatched categorized assumptions, the steps for generating the solver results file comprises:

generating a solver setup script by feeding the solver setup script creation prompt to the multimodal LLM; and
executing the solver setup script by the multimodal LLM, to generate the solver results file, wherein if any errors occur during the execution of the solver setup script, the solver setup script along with a predefined solver setup script correction prompt is passed to the multimodal LLM to iteratively correct the solver setup script and generate the solver results file, and wherein the solver setup script correction prompt comprises (a) a plurality of errors during execution of the solver setup script and (b) the plurality of instructions for the multimodal LLM to analyse the error and refine the solver setup script.

7. The processor implemented method as claimed in claim 1, wherein the steps for generating the plurality of computational analysis result insights comprises:
feeding the computational analysis result insight prompt to the multimodal LLM,

wherein if the computational analysis result insight prompt is created based on one or more modified matched assumptions, the predefined fetching function is executed to load the plurality of computational analysis result insights directly from the predefined knowledge base; and

wherein if the computational analysis result insight prompt is created based on the one or more unmatched categorized assumptions, the steps for generating the plurality of computational analysis result insights comprises:

generating a postprocessing script by feeding the generated insights prompt to the multimodal LLM, wherein the solver results file is imported by the generated postprocessing script;

executing the generated postprocessing script by the multimodal LLM, to generate the plurality of visualizations, wherein if any error occur during the execution of the generated postprocessing script, the generated postprocessing script along with a predefined postprocessing script correction prompt is passed to the multimodal LLM to iteratively correct the generated postprocessing script and generate the plurality of visualizations, and wherein the postprocessing script correction prompt comprises (a) the plurality of errors during execution of the postprocessing script (b) the plurality of instructions for the multimodal LLM to analyze the error and refine the postprocessing script; and

feeding a visualization prompt embedded with the plurality of visualizations to the multimodal LLM, to generate the plurality of computational analysis result insights for the computational analysis of the industrial entity.

8. A system (100), comprising:

a memory (102) storing instructions;

one or more communication interfaces (106); and

one or more hardware processors (104) coupled to the memory (102) via the one or more communication interfaces (106), wherein the one or more hardware processors (104) are configured by the instructions to:

receive a user input comprising at least one of (a) one or more information documents, (b) a technical problem description, (c) a natural language description, (d) a reference engineering drawing, and (e) a plurality of web resources pertaining to a computational analysis of an industrial entity;

generate a plurality of questions, by a multimodal Large Language Model (LLM), based on the user input, wherein the plurality of questions pertains to a computational analysis information required by a plurality of workflows of the computational analysis of the industrial entity, and wherein the computational analysis information of the plurality of workflows comprises a geometry creation information, a mesh related information, a solver setup related information, and a postprocessing information;

generate a plurality of final assumptions, by the multimodal LLM, based on (i) a plurality of associated answers for the plurality of questions generated by the multimodal LLM, (ii) the user input , and (iii) an information extracted via a first search and a second search using a Retrieval-Augmented Generation (RAG) technique, wherein the information extracted via the first search and the second search comprises a set of answers for a set of skipped questions among the plurality of questions;

categorize the plurality of final assumptions into a plurality of current categorized assumptions comprising a plurality of current geometry assumptions, a plurality of current mesh assumptions, a plurality of current solver setup assumptions, and a plurality of current computational analysis result insight assumptions, based on the plurality of workflows of the computational analysis of the industrial entity;

extract a plurality of existing categorized assumptions based on the plurality of current categorized assumptions by the first search using the RAG technique, wherein the existing categorized assumptions comprises (i) a plurality of existing geometry assumptions, (ii) a plurality of existing mesh assumptions, (iii) a plurality of existing solver setup assumptions, and (iv) a plurality of existing computational analysis result insight assumptions in the knowledge base;

identify one or more matched categorized assumptions, and one or more unmatched categorized assumptions by comparing the plurality of current categorized assumptions with the plurality of existing categorized assumptions, wherein if one or more current categorized assumptions of the plurality of current categorized assumptions is exactly matching with one or more existing categorized assumptions of the plurality of existing categorized assumptions, the one or more matched categorized assumptions are replaced with a set of instructions to enable the multimodal LLM for executing a predefined fetching function, by the multimodal LLM, to generate one or more modified matched assumptions;

create a plurality of prompts comprising (i) a geometry creation prompt, (ii) a mesh creation prompt, (iii) a solver setup script creation prompt, (iv) and a computational analysis result insight prompt, by the multimodal LLM, based on the one or more modified matched assumptions, and the one or more unmatched categorized assumptions;

generate a Computer-Aided Design (CAD) file for the computational analysis of the industrial entity, using the geometry creation prompt, via the multimodal LLM;

generate a final mesh file for the computational analysis of the industrial entity, using the mesh creation prompt, and the generated CAD file, via the multimodal LLM;

generate a solver results file for the computational analysis of the industrial entity, using the solver setup script creation prompt, and the generated final mesh file, via the multimodal LLM; and

generate a plurality of computational analysis result insights for the computational analysis of the industrial entity, using the computational analysis result insight prompt and the generated solver results file, via the multimodal LLM.

9. The system as claimed in claim 8, wherein the steps for generating the plurality of final assumptions, by the multimodal LLM, using the Retrieval-Augmented Generation (RAG) technique comprises:

performing the first search and the second search on the user input and the plurality of associated answers for the plurality of questions generated, by the multimodal LLM, using the RAG technique, to obtain a missing information required by the plurality of workflows of the computational analysis; and

generating a plurality of initial assumptions serving as the plurality of final assumptions based on one of (i) an acceptance confirmation by a user, and (ii) one or more associated modifications applied to the plurality of initial assumptions, by the multimodal LLM;

10. The system as claimed in claim 8, wherein the knowledge base search is performed on the predefined knowledge base, wherein the predefined knowledge base comprises at least one of (a) a plurality of structured resources, and (b) a plurality of unstructured resources related to the computational analysis of the an industrial entity, comprising a plurality of predefined knowledge base entries, and wherein the plurality of predefined knowledge base entries comprises an information source metadata, the technical problem description, a plurality of geometry assumptions, a CAD script, the CAD file, a plurality of mesh assumptions, a plurality of mesh configurations, the final mesh file, a plurality of solver setup assumptions, a solver setup script, the solver results file, a plurality of computational analysis result insight assumptions, a post-processing script, a plurality of visualizations, and the plurality of computational analysis result insights.

11. The system as claimed in claim 8, wherein the steps for generating the CAD file comprises:
feeding the geometry creation prompt to the multimodal LLM,

wherein if the geometry creation prompt is created based on one or more modified matched assumptions, the predefined fetching function is executed to load the CAD file directly from the predefined knowledge base;
wherein if the geometry creation prompt is created based on the one or more unmatched categorized assumptions, the steps for generating the CAD file comprises:

feeding the geometry creation prompt to the multimodal LLM, to generate the CAD script;
executing the CAD script to generate a CAD model, by a CAD modeler; and
checking, via the multimodal LLM, if the created CAD model is compliant with the geometry creation information, wherein if the created CAD model is compliant with the geometry creation information, the created CAD model is exported as the CAD file, wherein if the created CAD model is not compliant with the geometry creation information, the CAD script is iteratively refined by feeding to the multimodal LLM along with a predefined CAD correction prompt until the created CAD model is compliant with the geometry creation information for exporting the created CAD model as the CAD file, and wherein the predefined CAD correction prompt comprises (a) a plurality of orthographic views of the generated CAD model with one or more dimension labels, (b) the reference engineering drawing of the CAD model, and (c) a plurality of instructions for the multimodal LLM to compare and correct the CAD script.

12. The system as claimed in claim 8, wherein the steps for generating the final mesh file comprises:

feeding the mesh creation prompt to the multimodal LLM,

wherein if the mesh creation prompt is created based on one or more modified matched assumptions, the predefined fetching function is executed to load the final mesh file directly from the predefined knowledge base; and

wherein if the mesh creation prompt is created based on the one or more unmatched categorized assumptions, the steps for generating the final mesh file comprises:

configuring a predefined meshing function based on the mesh creation prompt, by the multimodal LLM, to generate a configuration for the predefined meshing function, wherein the configuration for the predefined meshing function comprises a place holder for importing the CAD file, a predefined mesh size range, a plurality of system international (SI) unit choices, and a plurality of setup type choices;

importing the generated CAD file into the predefined meshing function;

executing the predefined meshing function, to obtain an initial mesh file along with a plurality of quality metrics; and

obtaining the final mesh file by comparing the plurality of quality metrics of the initial mesh file with a plurality of predefined threshold limits, wherein if the plurality of quality metrics of the initial mesh file is not in compliance with the plurality of predefined threshold limits, then the predefined meshing function is iteratively reconfigured based on the plurality of predefined threshold limits, to generate the final mesh file.

13. The system as claimed in claim 8, wherein the steps for generating the solver results file comprises:
feeding the solver setup script creation prompt to the multimodal LLM,

wherein if the solver setup script creation prompt is created based on one or more modified matched assumptions, the predefined fetching function is executed to load the solver results file directly from the predefined knowledge base; and

wherein if the geometry creation prompt is created based on the one or more unmatched categorized assumptions, the steps for generating the solver results file comprises:

generating a solver setup script by feeding the solver setup script creation prompt to the multimodal LLM; and executing the solver setup script by the multimodal LLM, to generate the solver results file, wherein if any errors occur during the execution of the solver setup script, the solver setup script along with a predefined solver setup script correction prompt is passed to the multimodal LLM to iteratively correct the solver setup script and generate the solver results file, and wherein the solver setup script correction prompt comprises (a) a plurality of errors during execution of the solver setup script and (b) the plurality of instructions for the multimodal LLM to analyse the error and refine the solver setup script.

14. The system as claimed in claim 8, wherein the steps for generating the plurality of computational analysis result insights comprises:
feeding the computational analysis result insight prompt to the multimodal LLM,

wherein if the computational analysis result insight prompt is created based on one or more modified matched assumptions, the predefined fetching function is executed to load the plurality of computational analysis result insights directly from the predefined knowledge base; and

wherein if the computational analysis result insight prompt is created based on the one or more unmatched categorized assumptions, the steps for generating the plurality of computational analysis result insights comprises:

generating a postprocessing script by feeding the generated insights prompt to the multimodal LLM, wherein the solver results file is imported by the generated postprocessing script;

executing the generated postprocessing script by the multimodal LLM, to generate the plurality of visualizations, wherein if any error occur during the execution of the generated postprocessing script, the generated postprocessing script along with a predefined postprocessing script correction prompt is passed to the multimodal LLM to iteratively correct the generated postprocessing script and generate the plurality of visualizations, and wherein the postprocessing script correction prompt comprises (a) the plurality of errors during execution of the postprocessing script (b) the plurality of instructions for the multimodal LLM to analyze the error and refine the postprocessing script; and

feeding a visualization prompt embedded with the plurality of visualizations to the multimodal LLM, to generate the plurality of computational analysis result insights for the computational analysis of the industrial entity.

15. One or more non-transitory machine-readable information storage mediums comprising one or more instructions which when executed by one or more hardware processors cause:

receiving a user input further comprising at least one of (a) one or more information documents, (b) a technical problem description, (c) a natural language description, (d) a reference engineering drawing, and (e) a plurality of web resources pertaining to a computational analysis of an industrial entity;

generating a plurality of questions, by a multimodal Large Language Model (LLM), based on the user input, wherein the plurality of questions pertains to a computational analysis information required by a plurality of workflows of the computational analysis of the industrial entity, and wherein the computational analysis information of the plurality of workflows comprises a geometry creation information, a mesh related information, a solver setup related information, and a postprocessing information;

generating a plurality of final assumptions, by the multimodal LLM, based on (i) a plurality of associated answers for the plurality of questions generated by the multimodal LLM, (ii) the user input , and (iii) an information extracted via a first search and a second search using a Retrieval-Augmented Generation (RAG) technique, wherein the information extracted via the first search and the second search comprises a set of answers for a set of skipped questions among the plurality of questions;

categorizing the plurality of final assumptions into a plurality of current categorized assumptions further comprising a plurality of current geometry assumptions, a plurality of current mesh assumptions, a plurality of current solver setup assumptions, and a plurality of current computational analysis result insight assumptions, based on the plurality of workflows of the computational analysis of the industrial entity;

extracting a plurality of existing categorized assumptions based on the plurality of current categorized assumptions by the first search using the RAG technique, wherein the existing categorized assumptions comprises (i) a plurality of existing geometry assumptions, (ii) a plurality of existing mesh assumptions, (iii) a plurality of existing solver setup assumptions, and (iv) a plurality of existing computational analysis result insight assumptions in the knowledge base;

identifying one or more matched categorized assumptions, and one or more unmatched categorized assumptions by comparing the plurality of current categorized assumptions with the plurality of existing categorized assumptions, wherein if one or more current categorized assumptions of the plurality of current categorized assumptions is exactly matching with one or more existing categorized assumptions of the plurality of existing categorized assumptions, the one or more matched categorized assumptions are replaced with a set of instructions to enable the multimodal LLM for executing a predefined fetching function, by the multimodal LLM, to generate one or more modified matched assumptions;

creating a plurality of prompts further comprising (i) a geometry creation prompt, (ii) a mesh creation prompt, (iii) a solver setup script creation prompt, (iv) and a computational analysis result insight prompt, by the multimodal LLM, based on the one or more modified matched assumptions, and the one or more unmatched categorized assumptions;

generating a Computer-Aided Design (CAD) file for the computational analysis of the industrial entity, using the geometry creation prompt, via the multimodal LLM;

generating a final mesh file for the computational analysis of the industrial entity, using the mesh creation prompt, and the generated CAD file, via the multimodal LLM;

generating a solver results file for the computational analysis of the industrial entity, using the solver setup script creation prompt, and the generated final mesh file, via the multimodal LLM; and

generating a plurality of computational analysis result insights for the computational analysis of the industrial entity, using the computational analysis result insight prompt and the generated solver results file, via the multimodal LLM.

**FIG. 1**

User Input

| Information Documents, Technical Problem Description, Natural Language Description, Reference Engineering Drawing, and Web Resources |

→

| Questions Generation (Multimodal LLM) |

| Knowledge Base |

→

| Assumptions (Multimodal LLM) |

| Assumptions Categorization |

| Prompts Creation |

| CAD (Multimodal LLM) |

| Mesh (Multimodal LLM) |

| Solver Results (Multimodal LLM) |

| Computational Analysis Result Insights (Multimodal LLM) |

**FIG. 2**

300

Receiving a user input comprising at least one of (a) one or more information documents (b) a technical problem description, (c) a natural language description, (d) a reference engineering drawing, and (e) a plurality of web resources pertaining to a computational analysis of an industrial entity **302**

Generating plurality of questions by a multimodal Large Language Model (LLM) based on the user input **304**

Generating a plurality of assumptions, by the multimodal LLM, based on (i) a plurality of associated answers for the plurality of questions generated by the multimodal LLM, (ii) the user input, and (iii) an information extracted via a first search and a second search using a Retrieval-Augmented Generation (RAG) technique **306**

Categorizing the plurality of final assumptions into a plurality of current categorized assumptions based on a plurality of workflows of the computational analysis of the industrial entity **308**

Extracting a plurality of existing categorized assumptions based on the plurality of current categorized assumptions by the first search using the RAG technique **310**

Identifying one or more matched categorized assumptions, and one or more unmatched categorized assumptions by comparing the plurality of current categorized assumptions with the plurality of existing categorized assumptions **312**

A

**FIG. 3A**

300

(A)

Creating a plurality of prompts comprising (i) a geometry creation prompt, (ii) a mesh creation prompt, (iii) a solver setup script creation prompt, (iv) and a computational analysis result insight prompt, by the multimodal LLM, based on the one or more modified matched assumptions, and the one or more unmatched categorized assumptions **314**

Generating a Computer-Aided Design (CAD) file for the computational analysis of the industrial entity, using the geometry creation prompt, via the multimodal LLM **316**

Generating a final mesh file for the computational analysis of the industrial entity, using the mesh creation prompt, and the generated CAD file **318**

Generating a solver results file for the computational analysis of the industrial entity, using the solver script creation prompt, and the generated final mesh file **320**

Generating a plurality of computational analysis result insights for the computational analysis of the industrial entity, using the computational analysis result insight prompt and the generated solver results file **322**

**FIG. 3B**

**FIG. 4**

**FIG. 5**

**FIG. 6A**

High
y-velocity

Low
y-velocity

**FIG. 6B**

Europäisches
Patentamt

European
Patent Office

Office européen
des brevets

# EUROPEAN SEARCH REPORT

**Application Number**

EP 25 22 2063

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y,D | ALEXIADIS ALESSIO ET AL: "From text to tech: Shaping the future of physics-based simulations with AI-driven generative models", RESULTS IN ENGINEERING, [Online] vol. 21, 30 December 2023 (2023-12-30), page 101721, XP093389580, ISSN: 2590-1230, DOI: 10.1016/j.rineng.2023.101721 Retrieved from the Internet: URL:https://pdf.sciencedirectassets.com/32 0278/1-s2.0-S2590123023X0005X/1-s2.0-S2590 123023008484/main.pdf?hash=a544ef762a45a48 5541ce9da8e0f807aed470b6e6704bc2405790914d d802dda&host=68042c943591013ac2b2430a89b27 0f6af2c76d8dfd086a07176afe7c76c2c61&pii=S2 590123023008484&tid=spdf-6e7f7ef1-d3bc-42e 9-9653-e6c> [retrieved on 2026-04-20] * the whole document * ----- | 1-15 | INV. G06F30/20 G06F30/27 G06F40/30 G06N5/022 |
| Y | YUXUAN CHEN ET AL: "MetaOpenFOAM: an LLM-based multi-agent framework for CFD", ARXIV.ORG CORNELL UNIVERSITY LIBRARY, 201 OLIN LIBRARY CORNELL UNIVERSITY ITHACA, NY 14853, [Online] 31 July 2024 (2024-07-31), XP091839553, [retrieved on 2024-08-11] * abstract * * sections 2-4; page 4 - page 14; figures 1-3 * ----- -/-- | 1-15 | **TECHNICAL FIELDS SEARCHED (IPC)**  G06F G06E G06N |

The present search report has been drawn up for all claims

| Place of search | Date of completion of the search | Examiner |
|---|---|---|
| Munich | 23 April 2026 | Lindner, Anja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

Europäisches
Patentamt

European
Patent Office

Office européen
des brevets

# EUROPEAN SEARCH REPORT

**Application Number**

EP 25 22 2063

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | KAMEL ALRASHEDY ET AL: "Generating CAD Code with Vision-Language Models for 3D Designs", ARXIV.ORG CORNELL UNIVERSITY LIBRARY, 201 OLIN LIBRARY CORNELL UNIVERSITY ITHACA, NY 14853, [Online] 7 October 2024 (2024-10-07), XP091906287, [retrieved on 2024-12-06] * abstract * * page 1 - page 6; figure 1 * | 1-15 | |
| A,D | VARUN KUMAR ET AL: "MyCrunchGPT: A chatGPT assisted framework for scientific machine learning", ARXIV.ORG CORNELL UNIVERSITY LIBRARY, 201 OLIN LIBRARY CORNELL UNIVERSITY ITHACA, NY 14853, [Online] 31 July 2023 (2023-07-31), XP091574949, [retrieved on 2023-08-02] * abstract * * sections 3-4; page 4 - page 16; figures 3, 5-20 * | 1-15 | TECHNICAL FIELDS SEARCHED (IPC) |
| A | SANDEEP PANDEY ET AL: "OpenFOAMGPT: a RAG-Augmented LLM Agent for OpenFOAM-Based Computational Fluid Dynamics", ARXIV.ORG CORNELL UNIVERSITY LIBRARY, 201 OLIN LIBRARY CORNELL UNIVERSITY ITHACA, NY 14853, [Online] 10 January 2025 (2025-01-10), XP091939199, [retrieved on 2025-02-13] * abstract * * sections II-III; page 5 - page 13; figures 1, 2, 3 * | 1-15 | |

The present search report has been drawn up for all claims

| Place of search | Date of completion of the search | Examiner |
|---|---|---|
| Munich | 23 April 2026 | Lindner, Anja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- IN 202521005381

**Non-patent literature cited in the description**

- **KUMAR, V.** ; **GLEYZER, L.** ; **KAHANA, A.** ; **SHUKLA, K.** ; **KARNIADAKIS, G. E.** *MyCrunchGPT: A chatGPT assisted framework for scientific machine learning*, 2023

- **PICARD, C.** ; **EDWARDS, K. M.** ; **DORIS, A. C.** ; **MAN, B.** ; **GIANNONE, G.** ; **ALAM, M. F.** ; **AHMED, F.** *From Concept to Manufacturing: Evaluating Vision-Language Models for Engineering Design.*, 2023
- **ALEXIADIS, A.** ; **GHIASSI, B.** *Results in Engineering*, 2024, vol. 21, 101721